# EUROPEAN PATENT APPLICATION

(11) **EP 4 053 890 A1**
(43) Date of publication of application: **07.09.2022**
(21) Application number: 22151285.8
(22) Date of filing: 13.01.2022
(51) Int. Cl.: H01L 21/768, H01L 23/522, H01L 23/528

(54) **TRANSISTOR ARRANGEMENTS WITH STACKED TRENCH CONTACTS AND GATE CONTACTS WITHOUT GATE CAPS**

(30) Priority: 03.03.2021 US 202117190539
(71) Applicant: INTEL Corporation, Santa Clara, CA 95054 (US)
(72) Inventor: Wei, Andy Chih-Hung, Yamhill, 97148 (US); Golonzka, Oleg, Beaverton, 97007 (US); Adibi-Rizi, Farshid, San Jose, 95120 (US)
(74) Representative: Goddar, Heinz J.

(57) **Abstract**

Described herein are fabrication processes and resulting transistor arrangements with trench contacts that have two parts - a first trench contact (TCN1) and a second trench contact (TCN2) - stacked over one another, and with gate contacts (VCGs). In such transistor arrangements, the TCN1 may be self-aligned to adjacent gates and may be used to make cell-level connections, the TCN2 may also make cell-level connections and may be provided after the self-aligned TCN1 formation and may have an inverse taper shape, the spacer around the TCN2 may be a higher dielectric constant dielectric material than conventional spacer materials, and the VCGs may be formed without the presence of any gate caps or after using only thin temporary gate caps. Fabrication processes and transistor arrangement described herein may provide several improvements in terms of increased edge placement error margin, cost-efficiency, and device performance.

## Description

### Technical Field

This disclosure relates generally to the field of semiconductor devices, and more specifically, to transistor arrangements.

### Background

A field-effect transistor (FET), e.g., a metal-oxide-semiconductor (MOS) FET (MOSFET), is a three-terminal device that includes source, drain, and gate terminals and uses electric field to control current flowing through the device. A FET typically includes a semiconductor channel material, a source and a drain regions provided in the channel material, and a gate stack that includes at least a gate electrode material and may also include a gate dielectric material, the gate stack provided over a portion of the channel material between the source and the drain regions. Because gate electrode materials often include metals, gates of transistors are commonly referred to as "metal gates."

Recently, FETs with non-planar architectures, such as FinFETs (also sometimes referred to as "wrap-around gate transistors" or "tri-gate transistors") and nanoribbon/nanowire transistors (also sometimes referred to as "all-around gate transistors"), have been extensively explored as alternatives to transistors with planar architectures.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 is a perspective view of an example FinFET, according to some embodiments of the disclosure.
FIG. 2 is a top-down view of an example integrated circuit (IC) structure in which a transistor arrangement with one or more stacked trench contacts and one or more gate contacts without gate caps according to various embodiments of the disclosure may be implemented.
FIG. 3 is a top-down view of an IC structure that is similar to the IC structure of FIG. 2, further illustrating an example transistor arrangement with stacked trench contacts and gate contacts without gate caps, according to some embodiments of the disclosure.
FIG. 4 provides a flow diagram of an example method of manufacturing an IC structure with a transistor arrangement with one or more stacked trench contacts and one or more gate contacts without gate caps, according to one embodiment of the disclosure.
FIGS. 5A-5H are cross-sectional side views illustrating different example stages in the manufacture of a transistor arrangement with one or more stacked trench contacts and one or more gate contacts without gate caps using the method of FIG. 4, according to some embodiments of the present disclosure.
FIGS. 6A-6C are cross-sectional side views illustrating different example stages in the manufacture of an alternative transistor arrangement with one or more stacked trench contacts and one or more gate contacts without gate caps using the method of FIG. 4, according to some embodiments of the present disclosure.
FIGS. 7A-7B are cross-sectional side views illustrating different example stages in the manufacture of an alternative transistor arrangement with one or more stacked trench contacts and one or more gate contacts without gate caps that could be implemented additional to the method of FIG. 4, according to some embodiments of the present disclosure.
FIGS. 8A and 8B are top views of, respectively, a wafer and dies that may include one or more transistor arrangements with one or more stacked trench contacts and one or more gate contacts without gate caps in accordance with any of the embodiments disclosed herein.
FIG. 9 is a cross-sectional side view of an IC package that may include one or more transistor arrangements with one or more stacked trench contacts and one or more gate contacts without gate caps in accordance with any of the embodiments disclosed herein.
FIG. 10 is a cross-sectional side view of an IC device assembly that may include one or more transistor arrangements with one or more stacked trench contacts and one or more gate contacts without gate caps in accordance with any of the embodiments disclosed herein.
FIG. 11 is a block diagram of an example computing device that may include one or more transistor arrangements with one or more stacked trench contacts and one or more gate contacts without gate caps in accordance with any of the embodiments disclosed herein.

### Detailed Description

### Overview

The systems, methods and devices of this disclosure each have several innovative aspects, no single one of which is solely responsible for all of the desirable attributes disclosed herein. Details of one or more implementations of the subject matter described in this specification are set forth in the description below and the accompanying drawings.

For purposes of illustrating transistor arrangements with one or more stacked trench contacts and/or one or more gate contacts without gate caps, proposed herein, it might be useful to first understand phenomena that may come into play in such arrangements. The following foundational information may be viewed as a basis from which the present disclosure may be properly explained. Such information is offered for purposes of explanation only and, accordingly, should not be construed in any way to limit the broad scope of the present disclosure and its potential applications. While some of the following descriptions may be provided for the example of transistors being implemented as FinFETs, embodiments of the present disclosure are equally applicable to transistor arrangements employing transistors of other architectures, such as nanoribbon or nanowire transistors, as well as to planar transistors.

As described above, recently, FETs with non-planar architectures, such as FinFETs and nanoribbon/nanowire transistors, have been extensively explored as alternatives to transistors with planar architectures.

In a FinFET, a semiconductor structure shaped as a fin extends away from a base (e.g., from a semiconductor substrate), and a gate stack may wrap around the upper portion of the fin (i.e., the portion farthest away from the base), potentially forming a gate on 3 sides of the fin. The portion of the fin around which the gate stack wraps around is referred to as a "channel" or a "channel portion" of a FinFET. A semiconductor material of the channel portion is commonly referred to as a "channel material" of the transistor. A source region and a drain region are provided in the fin on the opposite sides of the gate stack, forming, respectively, a source and a drain of a FinFET.

In a nanoribbon transistor, a gate stack may be provided around a portion of an elongated semiconductor structure called "nanoribbon", forming a gate on all sides of the nanoribbon. The "channel" or the "channel portion" of a nanoribbon transistor is the portion of the nanoribbon around which the gate stack wraps around. A source region and a drain region are provided in the nanoribbon on each side of the gate stack, forming, respectively, a source and a drain of a nanoribbon transistor. In some settings, the term "nanoribbon" has been used to describe an elongated semiconductor structure that has a substantially rectangular transverse cross-section (i.e., a cross-section in a plane perpendicular to the longitudinal axis of the structure), while the term "nanowire" has been used to describe a similar structure but with a substantially circular transverse cross-section.

Taking FinFETs as an example, oftentimes, fabrication of an IC device having an array of FinFETs involves, first, providing a plurality of fins (typically parallel to one another), and then providing metal gate lines that cross over multiple fins (the metal gate lines often, but not always, being substantially perpendicular to the lengths, or longitudinal axes, of the fins, the metal gate lines provided in a plane substantially parallel to the plane of the support structure on which the fins are formed). A metal gate line crossing a first fin of the plurality of fins may form a gate of a transistor in the first fin, while the metal gate line crossing an adjacent second fin may form a gate of a transistor in the second fin. Since the metal gate line crosses over both the first and the second fins, the metal gate line is electrically continuous over the first and second fins, thereby providing an electrical coupling between the gate of the transistor in the first fin and the gate of the transistor in the second fin. In a later part of a fabrication process, it may be desirable to disrupt this continuity, e.g., if the design is such that it requires that the gate of the transistor in the first fin is decoupled from the gate of the transistor in the second fin. Also in a later part of a fabrication process, trench contacts are formed, where, as used herein, the term "trench contact" refers to a structure that is supposed to provide electrical connectivity to (i.e.., is a contact) to source or drain (S/D) contacts of a transistor. In addition, gate contacts are formed, where the term "gate contact" refers to a structure that is supposed to provide electrical connectivity to (i.e.., is a contact) to a gate (i.e., to a gate metal line) of a transistor.

For the past several decades, the scaling of features in ICs has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for the ever-increasing capacity, however, is not without issue. The necessity to optimize the performance of each device becomes increasingly significant and such optimization is far from trivial.

One challenge that arises with the ever-decreasing dimensions of ICs is that the overlay between the electrically conductive structures of trench contacts and metal gates, as well as the overlay between the electrically conductive structures of trench contacts and adjacent gate contacts generally need to be controlled to high tolerances. To that end, the term "edge placement error margin" refers to a measure of how much misalignment between these electrically conductive structures may be tolerated. On one hand, etch selectivity between different materials may be used to ensure that proper contacts between different electrically conductive structures are made, where two materials may be described as "sufficiently etch-selective" if etchants used to etch one material do not substantially etch the other material, and vice versa. However, as the transistor dimensions become even smaller over time, relying only on etch selectivity may not be enough to allow adequate over-etch to ensure no open contacts or shorts at small dimensions. One the other hand, complex fabrication processes may be implemented where multiple mask and polish processes are used, and where an intricate series of fabrication steps involving multiple liners and helmets may allow addressing the edge placement error margin issues, but such fabrication processes may not always be sufficiently cost-efficient. Another challenge with the ever-decreasing dimensions of ICs is that gate resistance may be relatively large.

Described herein are fabrication processes and resulting transistor arrangements with trench contacts that have two parts - a first trench contact (TCN1) and a second trench contact (TCN2) - stacked over one another, and with gate contacts (VCGs) without gate caps. Such transistor arrangements may be fabricated by forming a plurality of gates having one or more spacers on their sidewalls but not on their tops, forming at least one TCN1 over at least one S/D contact between two adjacent gates, providing a stack of a sacrificial material and a sacrificial etch cap, patterning the stack to create openings in the stack so that the remaining portion of the stack forms a replacement (i.e., sacrificial) TCN2 structure (e.g., a pillar) above the TCN1, providing a spacer at least partially enclosing sidewalls of the replacement TCN2 structure, filling the remaining openings with a dielectric, removing the replacement TCN2 structure and filling the resulting openings with an electrically conductive material to form the TCN2. One or more VCGs may then be formed in the dielectric between the TCN2 of adjacent S/D contacts. In such transistor arrangements, the TCN1 may be self-aligned to the adjacent gates of the transistor arrangement using only a thin temporary gate cap and may be used to make cell-level connections, the TCN2 may be provided after the self-aligned TCN1 formation and have an inverse taper shape (i.e., it may narrow at its end that is farther away from the S/D contact), the spacer around the TCN2 may be a higher dielectric constant dielectric material than conventional interlayer dielectric materials such as oxides (e.g., higher than about 3.7-4.1, e.g., up to about 9), and the VCGs may be formed to contact a structure without any gate cap. Fabrication processes and transistor arrangement described herein may provide several improvements in terms of increased edge placement error margin, dielectric breakdown margin, cost-efficiency, and device performance, compared to conventional approaches to forming trench and gate contacts. For example, one improvement is that such a fabrication process allows providing a direct aligned gate via contact to the gate, with sufficient edge placement error margin to sustain time-dependent dielectric breakdown. Another improvement is that inverse taper shape of the TCN2 may advantageously increase distance between the TCN2 and adjacent VCG (which would typically have a non-inverse taper shape, i.e., it would narrow at its end that is closer to the gate), which may increase the edge placement error margin as well as decrease the probability of an unintended short-circuit between the TCN2 and the adjacent VCG and the probability of a dielectric breakdown between the TCN2 and the adjacent VCG. Yet another improvement may be realized if the spacer around the TCN2 is a higher dielectric constant material than silicon oxide or low-k dielectrics conventionally used as spacer material because using such a material (e.g., silicon nitride) as a spacer for the TCN2 allows using a thinner spacer to realize the same breakdown voltage as if a lower dielectric constant spacer is used.

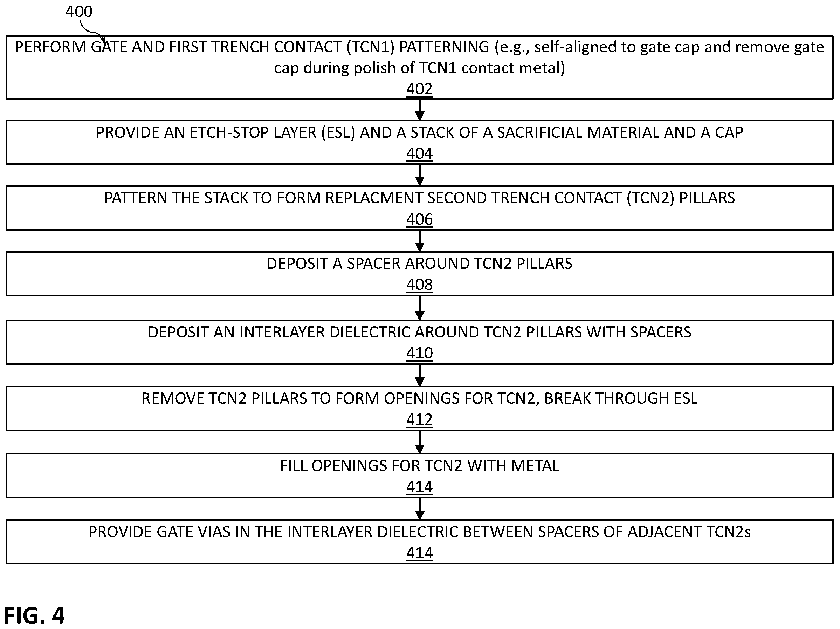

In some optional implementations, after forming the TCN1 but before providing the stack of a sacrificial material and an etch cap, the limited or all spacers on the sidewalls of two adjacent gates facing the TCN1 may be recessed, and the resulting recesses may then be re-filled with a dielectric material. Because the recesses are relatively high-aspect ratio openings, re-filling them with a dielectric material may result in a formation of a void substantially in the center of each re-filled recess. Such voids may advantageously decrease capacitance between adjacent gates and the TCN1, e.g., decrease by about 10-20% gate to contact capacitance. While such use of voids is described herein in context of the fabrication process as summarized above (e.g., as shown in FIG. 4), in other embodiments, such voids may be advantageously used to decrease capacitance in transistor arrangements fabricated using other processes as well (e.g., the voids as described herein may be combined with any conventional ways to provide transistor arrangements).

While descriptions provided herein refer to FinFETs, these descriptions are equally applicable to embodiments any other non-planar FETs besides FinFETs, e.g., to nanoribbon transistors, nanowire transistors, or transistors such as nanoribbon/nanowire transistors but having transverse cross-sections of any geometry (e.g., oval, or a polygon with rounded corners).

IC structures as described herein, in particular transistor arrangements with one or more stacked trench contacts and/or one or more gate contacts without gate caps as described herein, may be used for providing electrical connectivity to one or more components associated with an IC or/and between various such components. In various embodiments, components associated with an IC include, for example, transistors, diodes, power sources, resistors, capacitors, inductors, sensors, transceivers, receivers, antennas, etc. Components associated with an IC may include those that are mounted on IC or those connected to an IC. The IC may be either analog or digital and may be used in a number of applications, such as microprocessors, optoelectronics, logic blocks, audio amplifiers, etc., depending on the components associated with the IC. The IC may be employed as part of a chipset for executing one or more related functions in a computer.

For purposes of explanation, specific numbers, materials and configurations are set forth in order to provide a thorough understanding of the illustrative implementations. However, it will be apparent to one skilled in the art that the present disclosure may be practiced without the specific details or/and that the present disclosure may be practiced with only some of the described aspects. In other instances, well-known features are omitted or simplified in order not to obscure the illustrative implementations.

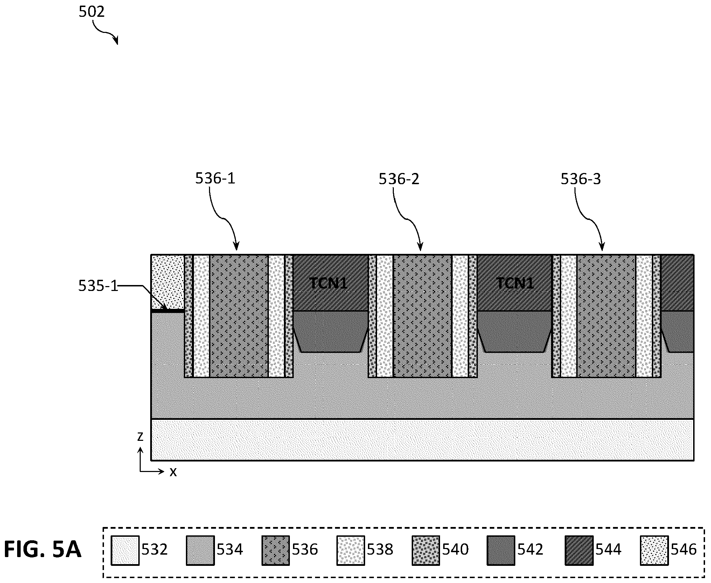

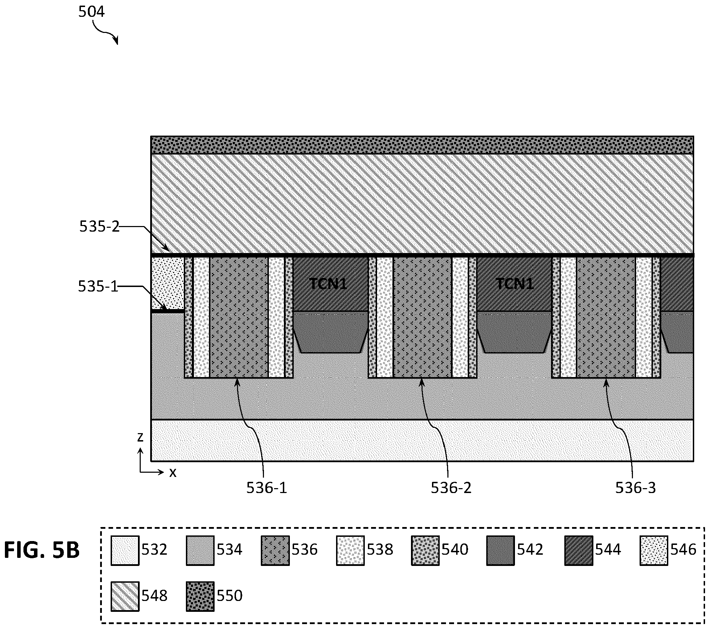

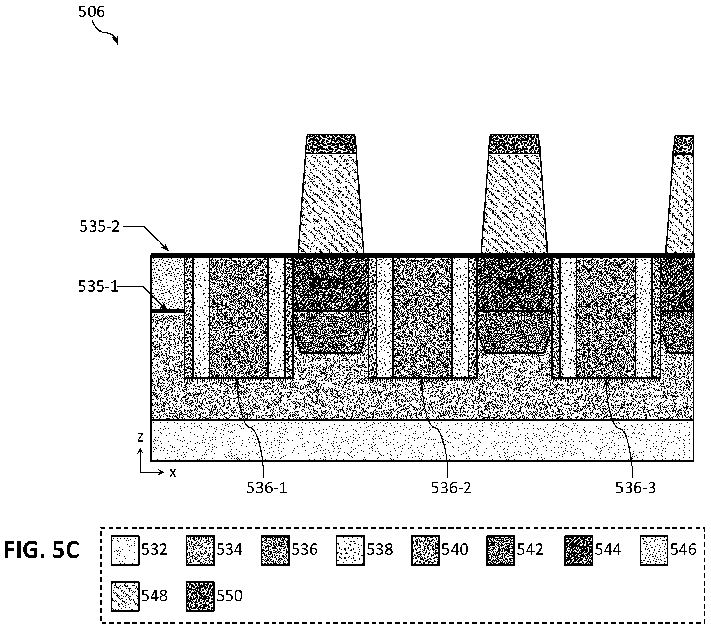

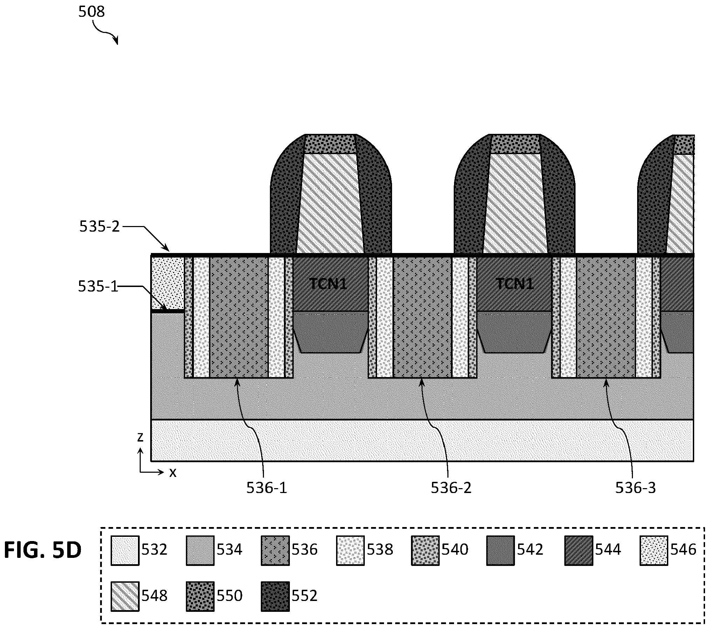

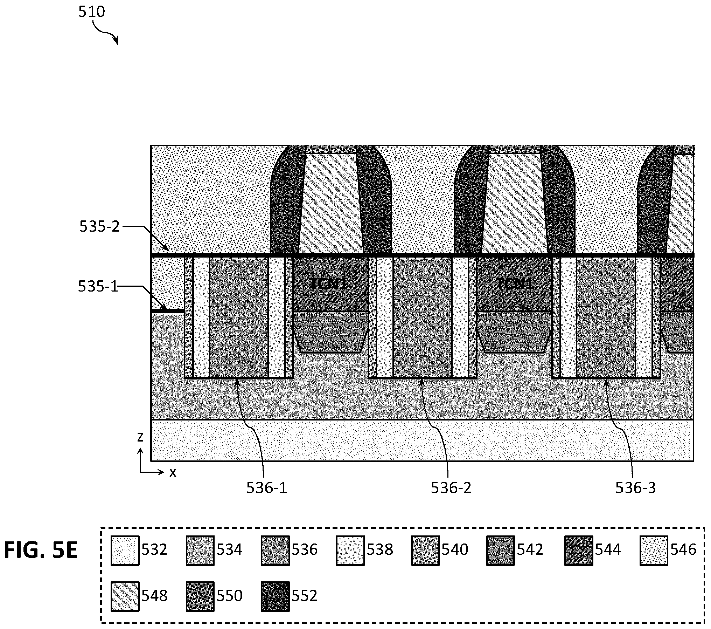

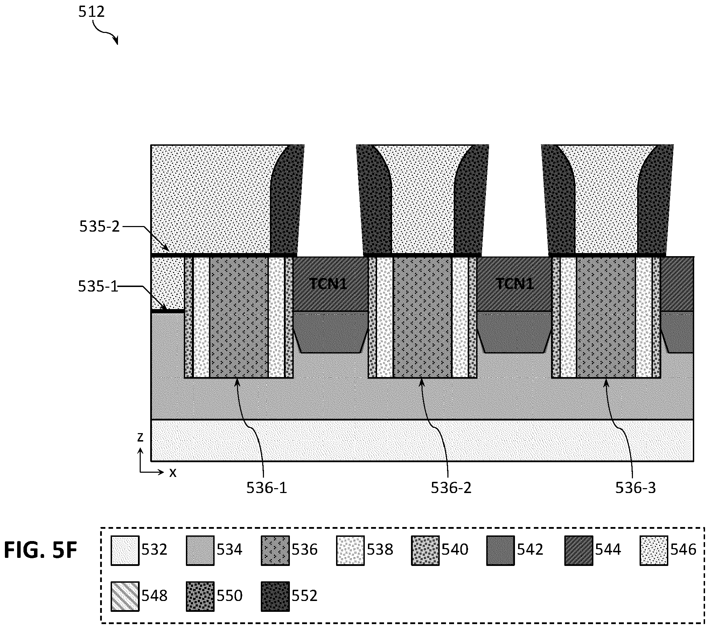

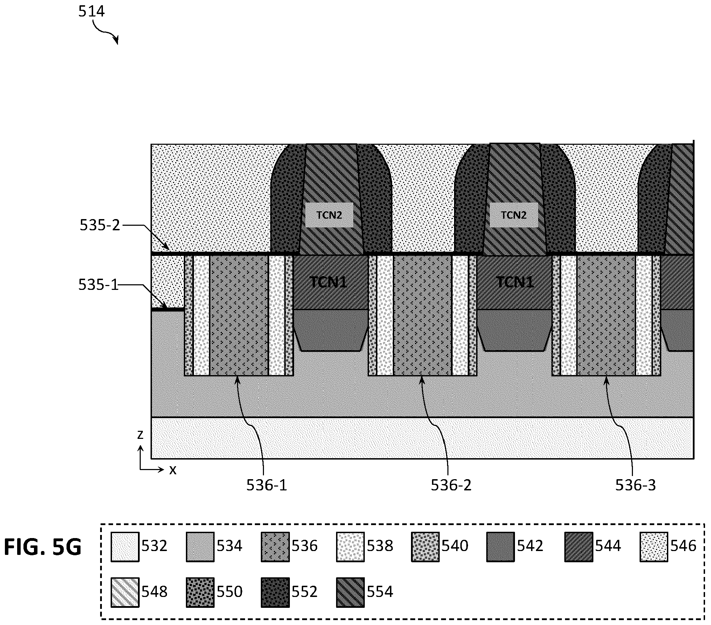

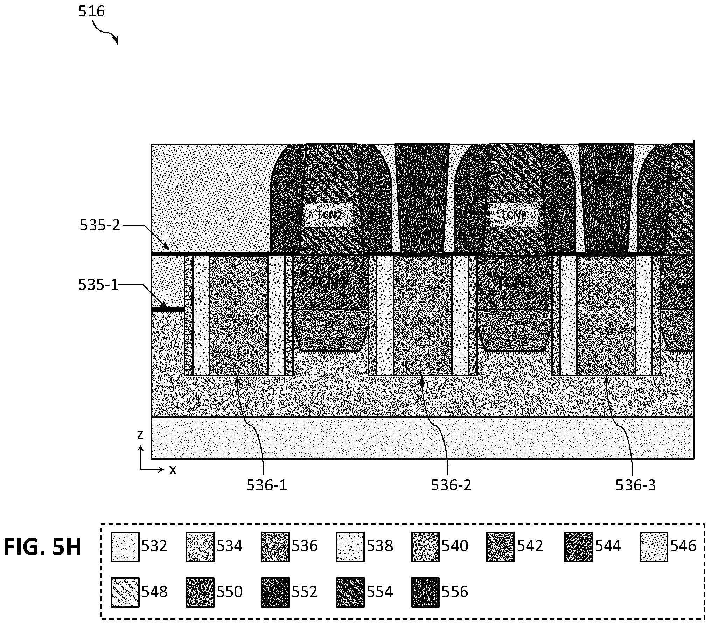

Further, references are made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense. For convenience, if a collection of drawings designated with different letters are present, e.g., FIGS. 5A-5H, such a collection may be referred to herein without the letters, e.g., as "FIG. 5."

In the drawings, some schematic illustrations of example structures of various devices and assemblies described herein may be shown with precise right angles and straight lines, this is simply for ease of illustration, and embodiments of these assemblies may be curved, rounded, or otherwise irregularly shaped as dictated by, and sometimes inevitable due to, the manufacturing processes used to fabricate semiconductor device assemblies. Therefore, it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication. Furthermore, although a certain number of a given element may be illustrated in some of the drawings (e.g., a certain number of stacked trench contacts, a certain number of gate contacts, a certain number of metal gate lines, etc.), this is simply for ease of illustration, and more, or less, than that number may be included in a transistor arrangement with one or more stacked trench contacts and/or one or more gate contacts without gate caps as described herein. Still further, various views shown in some of the drawings are intended to show relative arrangements of various elements therein. In other embodiments, various transistor arrangements with one or more stacked trench contacts and/or one or more gate contacts without gate caps as described herein, or portions thereof, may include other elements or components that are not illustrated (e.g., transistor portions, various components that may be in electrical contact with any of the metal lines, etc.). Inspection of layout and mask data and reverse engineering of parts of a device to reconstruct the circuit using e.g., optical microscopy, TEM, or SEM, and/or inspection of a cross-section of a device to detect the shape and the location of various device elements described herein using e.g., Physical Failure Analysis (PFA) would allow determination of presence of transistor arrangements with one or more stacked trench contacts and/or one or more gate contacts without gate caps as described herein.

Various operations may be described as multiple discrete actions or operations in turn, in a manner that is most helpful in understanding the claimed subject matter. However, the order of description should not be construed as to imply that these operations are necessarily order dependent. These operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges.

The description uses the phrases "in an embodiment" or "in embodiments," which may each refer to one or more of the same or different embodiments. The terms "comprising," "including," "having," and the like, as used with respect to embodiments of the present disclosure, are synonymous. The disclosure may use perspective-based descriptions such as "above," "below," "top," "bottom," and "side" to explain various features of the drawings, but these terms are simply for ease of discussion, and do not imply a desired or required orientation. The accompanying drawings are not necessarily drawn to scale. Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

In the following detailed description, various aspects of the illustrative implementations will be described using terms commonly employed by those skilled in the art to convey the substance of their work to others skilled in the art.

For example, some descriptions may refer to a particular source or drain region or contact being either a source region/contact or a drain region/contact. However, unless specified otherwise, which region/contact of a transistor is considered to be a source region/contact and which region/contact is considered to be a drain region/contact is not important because under certain operating conditions, designations of source and drain are often interchangeable. Therefore, descriptions provided herein may use the term of a "S/D" region/contact to indicate that the region/contact can be either a source region/contact, or a drain region/contact.

In another example, if used, the terms "package" and "IC package" are synonymous, as are the terms "die" and "IC die," the term "insulating" means "electrically insulating," the term "conducting" means "electrically conducting," unless otherwise specified. Although certain elements may be referred to in the singular herein, such elements may include multiple subelements. For example, "an electrically conductive material" may include one or more electrically conductive materials.

In another example, if used, the terms "oxide," "carbide," "nitride," etc. refer to compounds containing, respectively, oxygen, carbon, nitrogen, etc., the term "high-k dielectric" refers to a material having a higher dielectric constant than silicon oxide, while the term "low-k dielectric" refers to a material having a lower dielectric constant than silicon oxide.

In yet another example, a term "interconnect" may be used to describe any element formed of an electrically conductive material for providing electrical connectivity to one or more components associated with an IC or/and between various such components. In general, the "interconnect" may refer to both trench contacts (also sometimes referred to as "lines") and vias. In general, a term "trench contact" may be used to describe an electrically conductive element isolated by a dielectric material typically comprising an interlayer low-k dielectric that is provided within the plane of an IC chip. Such trench contacts are typically arranged in several levels, or several layers, of metallization stacks. On the other hand, the term "via" may be used to describe an electrically conductive element that interconnects two or more trench contacts of different levels. To that end, a via may be provided substantially perpendicularly to the plane of an IC chip and may interconnect two trench contacts in adjacent levels or two trench contacts in not adjacent levels. A term "metallization stack" may be used to refer to a stack of one or more interconnects for providing connectivity to different circuit components of an IC chip.

Furthermore, the term "connected" may be used to describe a direct electrical or magnetic connection between the things that are connected, without any intermediary devices, while the term "coupled" may be used to describe either a direct electrical or magnetic connection between the things that are connected, or an indirect connection through one or more passive or active intermediary devices. The term "circuit" may be used to describe one or more passive and/or active components that are arranged to cooperate with one another to provide a desired function.

The terms "substantially," "close," "approximately," "near," and "about," generally refer to being within +/- 20% of a target value based on the context of a particular value as described herein or as known in the art. Similarly, terms indicating orientation of various elements, e.g., "coplanar," "perpendicular," "orthogonal," "parallel," or any other angle between the elements, generally refer to being within +/- 5-20% of a target value based on the context of a particular value as described herein or as known in the art.

### Example FinFET

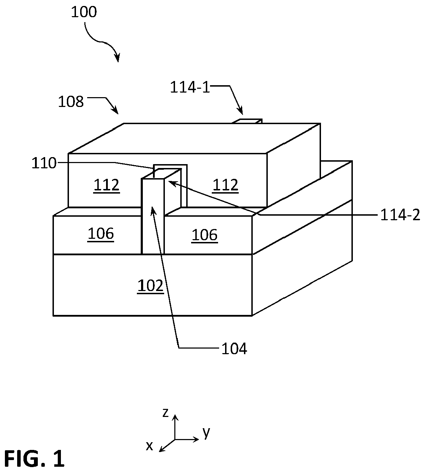

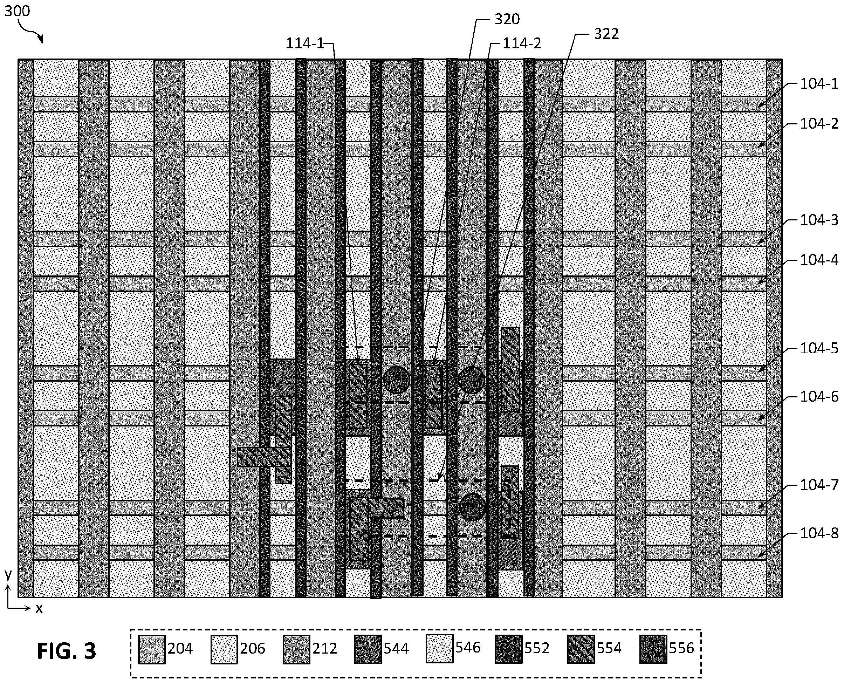

FIG. 1 is a perspective view of an example FinFET 100, according to some embodiments of the disclosure. The FinFET 100 illustrates one example of transistors that may be implemented in various transistor arrangements described herein, e.g., in the transistor arrangements shown in FIG. 3 and FIGS. 5-8. The FinFET 100 shown in FIG. 1 is intended to show relative arrangement(s) of some of the components therein. In various embodiments, the FinFET 100, or portions thereof, may include other components that are not illustrated (e.g., any further materials, such as e.g. spacer materials, surrounding the gate stack of the FinFET 100, electrical contacts to the S/D regions of the FinFET 100, etc.).

As shown in FIG. 1, the FinFET 100 may be provided over a base 102, where the term "base" may refer to any suitable support structure on which a transistor may be built, e.g., a substrate, a die, a wafer, or a chip. As also shown in FIG. 1, the FinFET 100 may include a fin 104, extending away from the base 102. A portion of the fin 104 that is closest to the base 102 may be enclosed by an insulator material 106, commonly referred to as a "shallow trench isolation" (STI). The portion of the fin 104 enclosed on its' sides by the STI 106 is typically referred to as a "subfin portion" or simply a "subfin." As further shown in FIG. 1, a gate stack 108 that includes at least a layer of a gate electrode material 112 and, optionally, a layer of a gate dielectric 110, may be provided over the top and sides of the remaining upper portion of the fin 104 (e.g., the portion above and not enclosed by the STI 106), thus wrapping around the upper-most portion of the fin 104. The portion of the fin 104 over which the gate stack 108 wraps around may be referred to as a "channel portion" of the fin 104 because this is where, during operation of the FinFET 100, a conductive channel may form. The channel portion of the fin 104 is a part of an active region of the fin 104. A first S/D region 114-1 and a second S/D region 114-2 (also commonly referred to as "diffusion regions") are provided on the opposite sides of the gate stack 108, forming source and drain terminals of the FinFET 100.

In general, implementations of the present disclosure may be formed or carried out on a support structure such as a semiconductor substrate, composed of semiconductor material systems including, for example, N-type or P-type materials systems. In one implementation, the semiconductor substrate may be a crystalline substrate formed using a bulk silicon or a silicon-on-insulator substructure. In other implementations, the semiconductor substrate may be formed using alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-V, group II-VI, or group IV materials. Although a few examples of materials from which the substrate may be formed are described here, any material that may serve as a foundation upon which transistor arrangements with one or more stacked trench contacts and/or one or more gate contacts without gate caps as described herein may be built falls within the spirit and scope of the present disclosure. In various embodiments, the base 102 may include any such substrate material that provides a suitable surface for forming the FinFET 100.

As shown in FIG. 1, the fin 104 may extend away from the base 102 and may be substantially perpendicular to the base 102. The fin 104 may include one or more semiconductor materials, e.g. a stack of semiconductor materials, so that the upper-most portion of the fin (namely, the portion of the fin 104 enclosed by the gate stack 108) may serve as the channel region of the FinFET 100. Therefore, as used herein, the term "channel material" of a transistor may refer to such upper-most portion of the fin 104, or, more generally, to any portion of one or more semiconductor materials in which a conductive channel between source and drain regions may be formed during operation of a transistor.

As shown in FIG. 1, the STI material 106 may enclose the sides of the fin 104. A portion of the fin 104 enclosed by the STI 106 forms a subfin. In various embodiments, the STI material 106 may be a low-k or high-k dielectric including, but not limited to, elements such as hafnium, silicon, oxygen, nitrogen, titanium, tantalum, lanthanum, aluminum, zirconium, barium, strontium, yttrium, lead, scandium, niobium, and zinc. Further examples of dielectric materials that may be used in the STI material 106 may include, but are not limited to silicon nitride, silicon oxide, silicon dioxide, silicon carbide, silicon nitride doped with carbon, silicon oxynitride, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate.

Above the subfin portion of the fin 104, the gate stack 108 may wrap around the fin 104 as shown in FIG. 1. In particular, the gate dielectric 110 may wrap around the upper-most portion of the fin 104, and the gate electrode 112 may wrap around the gate dielectric 110. The interface between the channel portion of the fin 104 and the subfin portion of the fin 104 is located proximate to where the gate electrode 112 ends.

The gate electrode 112 may include one or more gate electrode materials, where the choice of the gate electrode materials may depend on whether the FinFET 100 is a P-type metal-oxide-semiconductor (PMOS) transistor or an N-type metal-oxide-semiconductor (NMOS) transistor. For a PMOS transistor, gate electrode materials that may be used in different portions of the gate electrode 112 may include, but are not limited to, ruthenium, palladium, platinum, cobalt, nickel, and conductive metal oxides (e.g., ruthenium oxide). For an NMOS transistor, gate electrode materials that may be used in different portions of the gate electrode 112 include, but are not limited to, hafnium, zirconium, titanium, tantalum, aluminum, alloys of these metals, and carbides of these metals (e.g., hafnium carbide, zirconium carbide, titanium carbide, tantalum carbide, and aluminum carbide). In some embodiments, the gate electrode 112 may include a stack of a plurality of gate electrode materials, where zero or more materials of the stack are workfunction (WF) materials and at least one material of the stack is a fill metal layer. Further materials/layers may be included next to the gate electrode 112 for other purposes, such as to act as a diffusion barrier layer or/and an adhesion layer.

If used, the gate dielectric 110 may include a stack of one or more gate dielectric materials. In some embodiments, the gate dielectric 110 may include one or more high-k dielectric materials. In various embodiments, the high-k dielectric materials of the gate dielectric 110 may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric 110 may include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate. In some embodiments, an annealing process may be carried out on the gate dielectric 110 during manufacture of the FinFET 100 to improve the quality of the gate dielectric 110.

In some embodiments, the gate stack 108 may be surrounded by a dielectric spacer, not specifically shown in FIG. 1 but shown, e.g., in FIG. 5A as a gate spacer 540. The dielectric spacer may be configured to provide separation between the gate stacks 108 of different FinFETs 100 which may be provided along a single fin (e.g., different FinFETs provided along the fin 104, although FIG. 1 only illustrates one of such FinFETs), as well as between the gate stack 108 and the source/drain contacts disposed on each side of the gate stack 108. Such a dielectric spacer may include one or more low-k dielectric materials. Examples of the low-k dielectric materials that may be used as the dielectric spacer include, but are not limited to, silicon dioxide, carbon-doped oxide, silicon nitride, fused silica glass (FSG), and organosilicates such as silsesquioxane, siloxane, and organosilicate glass. Other examples of low-k dielectric materials that may be used as the dielectric spacer include organic polymers such as polyimide, polynorbornenes, benzocyclobutene, perfluorocyclobutane, or polytetrafluoroethylene (PTFE). Still other examples of low-k dielectric materials that may be used as the dielectric spacer include silicon-based polymeric dielectrics such as hydrogen silsesquioxane (HSQ) and methylsilsesquioxane (MSQ). Other examples of low-k materials that may be used in a dielectric spacer include various porous dielectric materials, such as for example porous silicon dioxide or porous carbon-doped silicon dioxide, where large voids or pores are created in a dielectric in order to reduce the overall dielectric constant of the layer, since voids can have a dielectric constant of nearly 1. When such a dielectric spacer is used, then the lower portions of the fin 104, e.g., the subfin portion of the fin 104, may be surrounded by the STI material 106 which may, e.g., include any of the high-k dielectric materials described herein.

In some embodiments, the fin 104 may be composed of semiconductor material systems including, for example, N-type or P-type materials systems. In some embodiments, the fin 104 may include a high mobility oxide semiconductor material, such as tin oxide, antimony oxide, indium oxide, indium tin oxide, titanium oxide, zinc oxide, indium zinc oxide, gallium oxide, titanium oxynitride, ruthenium oxide, or tungsten oxide. In some embodiments, the fin 104 may include a combination of semiconductor materials where one semiconductor material is used for the channel portion and another material, sometimes referred to as a "blocking material," is used for at least a portion of the subfin portion of the fin 104. In some embodiments, the subfin and the channel portions of the fin 104 are each formed of monocrystalline semiconductors, such as e.g. Si or Ge. In a first embodiment, the subfin and the channel portion of the fin 104 are each formed of compound semiconductors with a first sub-lattice of at least one element from group III of the periodic table (e.g., Al, Ga, In), and a second sub-lattice of at least one element of group V of the periodic table (e.g., P, As, Sb). The subfin may be a binary, ternary, or quaternary III-V compound semiconductor that is an alloy of two, three, or even four elements from groups III and V of the periodic table, including boron, aluminum, indium, gallium, nitrogen, arsenic, phosphorus, antimony, and bismuth.

For some example N-type transistor embodiments (i.e., for the embodiments where the FinFET 100 is an NMOS), the channel portion of the fin 104 may advantageously include a III-V material having a high electron mobility, such as, but not limited to InGaAs, InP, InSb, and InAs. For some such embodiments, the channel portion of the fin 104 may be a ternary III-V alloy, such as InGaAs, GaAsSb, InAsP, or InPSb. For some InₓGa₁₋ₓAs fin embodiments, In content (x) may be between 0.6 and 0.9, and may advantageously be at least 0.7 (e.g., In_{0.7}Ga_{0.3}As). In some embodiments with highest mobility, the channel portion of the fin 104 may be an intrinsic III-V material, i.e., a III-V semiconductor material not intentionally doped with any electrically active impurity. In alternate embodiments, a nominal impurity dopant level may be present within the channel portion of the fin 104, for example to further fine-tune a threshold voltage Vt, or to provide HALO pocket implants, etc. Even for impurity-doped embodiments however, impurity dopant level within the channel portion of the fin 104 may be relatively low, for example below 10¹⁵ dopant atoms per cubic centimeter (cm⁻³), and advantageously below 10¹³ cm⁻³. The subfin portion of the fin 104 may be a III-V material having a band offset (e.g., conduction band offset for N-type devices) from the channel portion. Example materials include, but are not limited to, GaAs, GaSb, GaAsSb, GaP, InAIAs, GaAsSb, AlAs, AIP, AlSb, and AIGaAs. In some N-type transistor embodiments of the FinFET 100 where the channel portion of the fin 104 is InGaAs, the subfin may be GaAs, and at least a portion of the subfin may also be doped with impurities (e.g., P-type) to a greater impurity level than the channel portion. In an alternate heterojunction embodiment, the subfin and the channel portion of the fin 104 each include group IV semiconductors (e.g., Si, Ge, SiGe). The subfin of the fin 104 may be a first elemental semiconductor (e.g., Si or Ge) or a first SiGe alloy (e.g., having a wide bandgap).

For some example P-type transistor embodiments (i.e., for the embodiments where the FinFET 100 is a PMOS), the channel portion of the fin 104 may advantageously be a group IV material having a high hole mobility, such as, but not limited to Ge or a Ge-rich SiGe alloy. For some example embodiments, the channel portion of the fin 104 may have a Ge content between 0.6 and 0.9, and advantageously may be at least 0.7. In some embodiments with highest mobility, the channel portion may be intrinsic III-V (or IV for P-type devices) material and not intentionally doped with any electrically active impurity. In alternate embodiments, one or more a nominal impurity dopant level may be present within the channel portion of the fin 104, for example to further set a threshold voltage Vt, or to provide HALO pocket implants, etc. Even for impurity-doped embodiments however, impurity dopant level within the channel portion is relatively low, for example below 10¹⁵ cm⁻³, and advantageously below 10¹³ cm⁻³. The subfin of the fin 104 may be a group IV material having a band offset (e.g., valance band offset for P-type devices) from the channel portion. Example materials include, but are not limited to, Si or Si-rich SiGe. In some P-type transistor embodiments, the subfin of the fin 104 is Si and at least a portion of the subfin may also be doped with impurities (e.g., N-type) to a higher impurity level than the channel portion.

Turning to the first S/D region 114-1 and the second S/D region 114-2 on respective different sides of the gate stack 108, in some embodiments, the first S/D region 114-1 may be a source region and the second S/D region 114-2 may be a drain region. In other embodiments this designation of source and drain may be interchanged, i.e., the first S/D region 114-1 may be a drain region and the second S/D region 114-2 may be a source region. Although not specifically shown in FIG. 1, the FinFET 100 may further include S/D electrodes (also commonly referred to as "S/D contacts"), formed of one or more electrically conductive materials, for providing electrical connectivity to the S/D regions 114, respectively. In some embodiments, the S/D regions 114 of the FinFET 100 may be regions of doped semiconductors, e.g., regions of doped channel material of the fin 104, so as to supply charge carriers for the transistor channel. In some embodiments, the S/D regions 114 may be highly doped, e.g. with dopant concentrations of about 1·10²¹ cm⁻³, in order to advantageously form Ohmic contacts with the respective S/D electrodes, although these regions may also have lower dopant concentrations and may form Schottky contacts in some implementations. Irrespective of the exact doping levels, the S/D regions 114 of the FinFET 100 are the regions having dopant concentration higher than in other regions, e.g., higher than a dopant concentration in a region of the semiconductor channel material between the first S/D region 114-1 and the second S/D region 114-2, and, therefore, may be referred to as "highly doped" (HD) regions.

In some embodiments, the S/D regions 114 may generally be formed using either an implantation/diffusion process or an etching/deposition process. In the former process, dopants such as boron, aluminum, antimony, phosphorous, or arsenic may be ion-implanted into the one or more semiconductor materials of the upper portion of the fin 104 to form the S/D regions 114. An annealing process that activates the dopants and causes them to diffuse further into the fin 104 may follow the ion implantation process. In the latter process, the one or more semiconductor materials of the fin 104 may first be etched to form recesses at the locations for the future source and drain regions. An epitaxial deposition process may then be carried out to fill the recesses with material (which may include a combination of different materials) that is used to fabricate the S/D regions 114. In some implementations, the S/D regions 114 may be fabricated using a silicon alloy such as silicon germanium or silicon carbide. In some implementations, the epitaxially deposited silicon alloy may be doped in situ with dopants such as boron, arsenic, or phosphorous. In further embodiments, the S/D regions 114 may be formed using one or more alternate semiconductor materials such as germanium or a group III-V material or alloy. Although not specifically shown in the perspective illustration of FIG. 1, in further embodiments, one or more layers of metal and/or metal alloys may be used to form the source and drain contacts (i.e., electrical contacts to each of the S/D regions 114).

The FinFET 100 may have a gate length, GL, (i.e. a distance between the first S/D region 114-1 and the second S/D region 114-2), a dimension measured along the fin 104 in the direction of the x-axis of the example reference coordinate system x-y-z shown in FIG. 1, which may, in some embodiments, be between about 5 and 40 nanometers, including all values and ranges therein (e.g. between about 10 and 35 nanometers, or between about 15 and 25 nanometers). The fin 104 may have a thickness, a dimension measured in the direction of the y-axis of the reference coordinate system x-y-z shown in FIG. 1, that may, in some embodiments, be between about 4 and 15 nanometers, including all values and ranges therein (e.g. between about 5 and 10 nanometers, or between about 7 and 12 nanometers). The fin 104 may have a height, a dimension measured in the direction of the z-axis of the reference coordinate system x-y-z shown in FIG. 1, which may, in some embodiments, be between about 30 and 350 nanometers, including all values and ranges therein (e.g. between about 30 and 200 nanometers, between about 75 and 250 nanometers, or between about 150 and 300 nanometers).

Although the fin 104 illustrated in FIG. 1 is shown as having a rectangular cross-section in a z-y plane of the reference coordinate system shown in FIG. 1, the fin 104 may instead have a cross-section that is rounded or sloped at the "top" of the fin 104, and the gate stack 108 (including the different portions of the gate dielectric 110) may conform to this rounded or sloped fin 104. In use, the FinFET 100 may form conducting channels on three "sides" of the channel portion of the fin 104, potentially improving performance relative to single-gate transistors (which may form conducting channels on one "side" of a channel material or substrate) and double-gate transistors (which may form conducting channels on two "sides" of a channel material or substrate).

While FIG. 1 illustrates a single FinFET 100, in some embodiments, a plurality of FinFETs may be arranged next to one another (with some spacing in between) along the fin 104.

### Example ICstructures with stacked trench contacts and gate contacts without gate caps

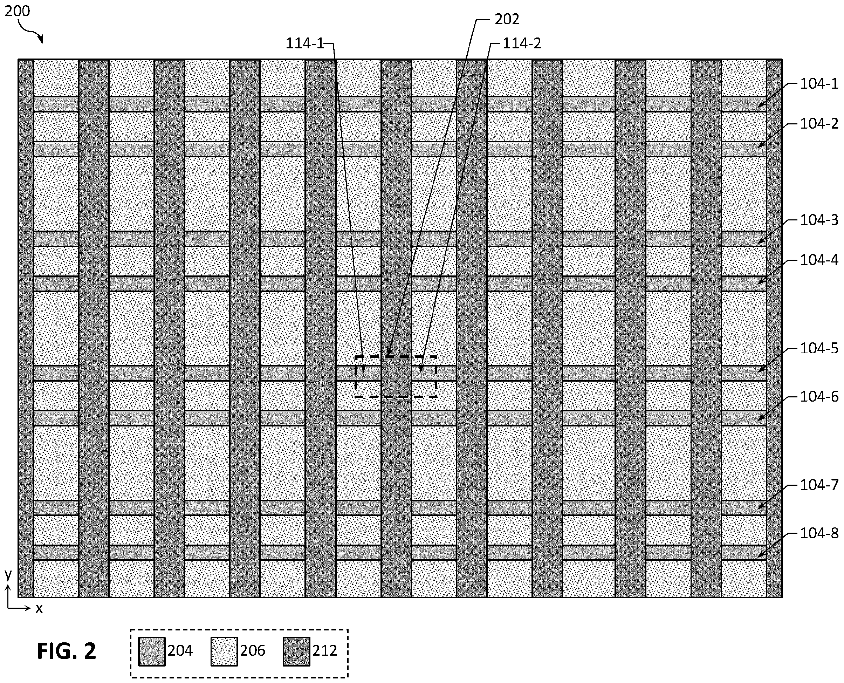

FIGS. 2 and 3 provide top-down views (i.e., the views of the x-y plane of the example reference coordinate system shown in FIG. 1) of an example IC structure in which transistor arrangements with one or more stacked trench contacts and/or one or more gate contacts without gate caps according to various embodiments of the present disclosure may be implemented. In particular, FIG. 2 illustrates an IC structure 200 without any stacked trench contacts or gate contacts, while FIG. 3 illustrates an IC structure 300 with stacked trench contacts and gate contacts without gate caps, according to some embodiments of the disclosure. The transistor arrangements shown in FIGS. 2 and 3 are intended to show relative arrangement(s) of some of the components therein and in various embodiments, the IC structures shown in FIGS. 2 and 3, or portions thereof, may include other components that are not illustrated (e.g., any further materials, such as spacer materials, STI, S/D regions or electrical contacts thereto, etc.). Same holds for subsequent drawings of the present disclosure.

A legend provided within a dashed box at the bottom of FIGS. 2 and 3 illustrates colors/patterns used to indicate some portions or materials of some of the elements shown in FIGS. 2 and 3, so that these drawings are not cluttered by too many reference numerals (the same holds for subsequent drawings of the present disclosure that include a legend at the bottom of the drawings). For example, FIGS. 2 and 3 use different colors/patterns to identify a channel material 534 (e.g., the channel material of the fins 104), a gate electrode material 536 of metal gate lines, and a dielectric material 546 (referred to in the following as an "interlayer dielectric (ILD) material" 546). In addition, FIG. 3 further uses different colors/patterns to identify a TCN1 material 544, a TCN2 spacer material 552, a TCN2 material 554, and a VCG material 556.

The IC structures shown in FIGS. 2 and 3, and in some of the subsequent drawings, are examples of how a plurality of the FinFETs 100 may be arranged in an IC device. Therefore, the IC structures shown in FIGS. 2-3 and in some of the subsequent drawings illustrate some elements labeled with the same reference numerals as those used in FIG. 1 to indicate similar or analogous elements in these drawings, so that, in the interests of brevity, descriptions of a given element provided with reference to one drawing does not have to be repeated again for other drawings. For example, FIGS. 2 and 3 illustrate the fin 104 (in particular, a plurality of such fins), and example S/D regions 114 for one example FinFET of the IC structures of FIGS. 2 and 3. The same holds for subsequent drawings of the present disclosure - elements with reference numerals used in one drawing and shown again in another drawing refer to similar or analogous elements so that their descriptions do not have to be repeated for each drawing.

As shown in FIG. 2, the IC structure 200 may include a channel material 534 shaped into a plurality of fins 104, which, in some embodiments, may extend substantially parallel to one another and substantially perpendicular to a support structure over which they are provided (e.g., a support structure 532, shown in FIG. 5A). Different instances of the fins 104 are shown in FIG. 2 with a dash and a different reference numeral after the reference numeral for the fin, 104 (the same notation is used for other elements in other drawings). The IC structure 200 illustrates an example of eight fins 104, labeled as fins 104-1 through 104-8, but, in other embodiments, any other number of one or more fins 104 may be implemented in the IC structure 200.

Once the fins 104 are fabricated, metal gate lines 212 may be provided over the fins 104, crossing multiple fins 104. Different instances of the metal gate lines 212 are shown in FIG. 2 with a dash and a different reference numeral after the reference numeral for the metal gate line, 212 (the same notation is used for other elements in other drawings). The IC structure 200 illustrates an example of eleven metal gate lines 212, labeled as metal gate lines 212-1 through 212-11, but, in other embodiments, any other number of one or more metal gate lines 212 may be implemented in the IC structure 200.

In some embodiments, the metal gate lines 212 may extend substantially perpendicular to the length of the fins 104. For example, if the fins 104 extend in the direction of the x-axis of the example coordinate system used in the present drawings, as shown in FIG. 2 (i.e., if each of the fins 104 may have a long axis substantially parallel to the support structure over which they are provided (e.g., the base 102) and different fins 104 may extend substantially parallel to one another), then the metal gate lines 212 may extend in the direction of the y-axis, as is shown in FIG. 2. In some embodiments, the metal gate lines 212 may be shaped as ridges, substantially perpendicular to the length of the fins 104 and enclosing different portions of the fins 104. At least portions of the metal gate lines 212 provided over the fins 104, i.e., where gates of FinFETs may be formed, as described with reference to FIG. 1, may include the gate electrode material 536 (which may be an example of the gate electrode material 112, shown in FIG. 1), thus forming gate stacks 108, described above. In some embodiments, all of the metal gate lines 212 (i.e., also between the fins 104) are formed of one or more of the gate electrode material 536. In some embodiments, the gate electrode material 536 used in one portion of a given metal gate line 212 may have a material composition that is different from the material composition of the gate electrode material 536 used in another portion of that particular metal gate line 212. For example, the material composition of a portion of a given metal gate line 212 crossing the fins 104 in which NMOS transistors are to be formed may be different from the material composition of a portion of that metal gate line 212 crossing the fins 104 in which PMOS transistors are to be formed (since, as described above, different gate electrode materials may be better suited for NMOS and PMOS transistors). For example, the fins 104-1 and 104-2 may be fins in which NMOS transistors can be formed, while the fins 104-3 and 104-4 may be fins in which PMOS transistors can be formed.

A dashed contour shown in FIG. 2 illustrates an example of a FinFET 202 formed in one of the fins 104, namely, in the fin 104-5. The FinFET 202 may be an example of the FinFET 100, described above. FIG. 2 illustrates the S/D regions 114-1 and 114-2 for the FinFET 202, and a portion of the metal gate line 212 (namely, the metal gate line 212-6) crossing the fin 104-5 forms the gate stack 108 of the FinFET 202. A plurality of other such FinFETs are also shown in FIG. 2, although they are not specifically labeled with reference numerals in order to not clutter the drawings.

In some embodiments, a plurality of FinFETs 202 may be arranged to form a cell unit (or, simply, a "cell") with a particular logic function/functionality, and such cells may then be provided multiple times in an array form. Of course, in other embodiments of the IC structure 200, the FinFETs 202 may be arranged in ways that do not include repeating cell units.

FIG. 2 further illustrates that portions of the IC structure 200 surrounding the upper portions of the fins 104 may be enclosed by an ILD material 546, which may include one or more of the dielectric spacer materials, described above. Although the top-down view of FIG. 2 illustrates the tops of the fins 104 in the portions where the metal gate lines 212 are not crossing the fins, in some embodiments, the ILD material 546 may cover the tops of the fins 104 in those portions (in which case the fins 104 would not be visible in the top-down view of the IC structure 200).

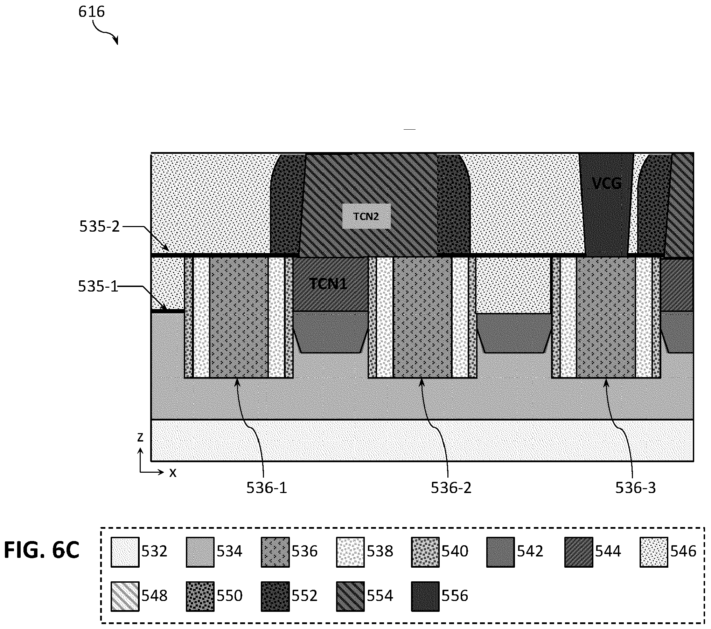

FIG. 3 is a top-down view of an IC structure 300 that is similar to the IC structure 200 of FIG. 2, further illustrating an example transistor arrangement with stacked trench contacts and gate contacts without gate caps, according to some embodiments of the disclosure. Transistor arrangements 320 and 322, each of which shown in FIG. 3 to be included within a respective dashed box, are portions of the IC structure 300 in which one or more stacked trench contacts and/or one or more gate contacts without gate caps may be implemented, according to some embodiments of the disclosure. In particular, the top-down view of the transistor arrangement 320 as shown in FIG. 3 corresponds to that of a transistor arrangement 516 of FIG. 5H, while the top-down view of the transistor arrangement 322 as shown in FIG. 3 corresponds to that of a transistor arrangement 616 of FIG. 6C, which will be described in greater detail below with reference to the manufacturing method and resulting devices. In order to not clutter the drawing, FIG. 3 does not specifically label examples of FinFETs such as the FinFET 202 shown in FIG. 2, but those FinFETs are present in the IC structure 300 as was described with reference to FIG. 2. Although not specifically shown in FIG. 3 outside of the dashed boxes illustrating the transistor arrangements 320, 322 in order to not clutter the drawing, the transistor arrangements 320, 322 as described herein may also be included in other portions of the IC structure 300.

### Example fabrication method

FIG. 4 provides a flow diagram of an example method 400 of manufacturing an IC structure with a transistor arrangement with one or more stacked trench contacts and/or one or more gate contacts without gate caps, according to one embodiment of the disclosure. For example, the method 400 may be used to manufacture an IC structure such as the IC structure 300, with a transistor arrangement such as any of the transistor arrangements shown in FIG. 3.

Although the operations of the method 400 are illustrated once each and in a particular order, the operations may be performed in any suitable order and repeated as desired. For example, one or more operations may be performed in parallel to manufacture, substantially simultaneously, multiple transistor arrangements with one or more stacked trench contacts and/or one or more gate contacts without gate caps as described herein. In another example, the operations may be performed in a different order to reflect the structure of a particular device assembly in which one or more transistor arrangements with one or more stacked trench contacts and/or one or more gate contacts without gate caps as described herein will be included.

In addition, the example manufacturing method 400 may include other operations not specifically shown in FIG. 4, such as various cleaning or planarization operations as known in the art. For example, in some embodiments, a support structure, as well as layers of various other materials subsequently deposited thereon, may be cleaned prior to, after, or during any of the processes of the method 400 described herein, e.g., to remove oxides, surface-bound organic and metallic contaminants, as well as subsurface contamination. In some embodiments, cleaning may be carried out using e.g., a chemical solutions (such as peroxide), and/or with ultraviolet (UV) radiation combined with ozone, and/or oxidizing the surface (e.g., using thermal oxidation) then removing the oxide (e.g., using hydrofluoric acid (HF)). In another example, the arrangements/devices described herein may be planarized prior to, after, or during any of the processes of the method 400 described herein, e.g., to remove overburden or excess materials. In some embodiments, planarization may be carried out using either wet or dry planarization processes, e.g., planarization be a chemical mechanical planarization (CMP), which may be understood as a process that utilizes a polishing surface, an abrasive and a slurry to remove the overburden and planarize the surface.

Various operations of the method 400 may be illustrated with reference to the example embodiments shown in FIGS. 5-7, illustrating cross-sectional side views for various stages in the manufacture of an example IC structure with a transistor arrangement with one or more stacked trench contacts and/or one or more gate contacts without gate caps, in accordance with various embodiments, but the method 400 may be used to manufacture any other suitable IC structures having one or more transistor arrangements with one or more stacked trench contacts and/or one or more gate contacts without gate caps according to any embodiments of the present disclosure. In particular, FIGS. 5-7 illustrate cross-sectional side views of various embodiments of the transistor arrangements of FIG. 3, with the cross-sections of the transistor arrangement taken along the length of the respective fins 104 (i.e., cross-sections along the x-z planes that contain the respective fins 104). Similar to FIGS. 2-3, a number of elements referred to in the description of FIGS. 5-7 with reference numerals are illustrated in these figures with different patterns, with a legend showing the correspondence between the reference numerals and patterns being provided at the bottom of each drawing page containing FIGS. 5-7.

The method 400 may begin with a process 402 that includes performing gate and TCN1 patterning. An example result of the process 402 is illustrated with an IC structure 502, shown in FIG. 5A. The process 402 may include, first, providing one or more (typically, a plurality) of fins over a support structure, then providing one or more (typically, a plurality) of metal gate lines as ridges crossing and wrapping around upper portions of the fins, and then performing TCN1 patterning in regions between the adjacent metal gate lines. The IC structure 502 illustrates a support structure 532 and a channel material 534 of one of the fins 104 (e.g., of the fin 104-5, shown in FIG. 3), extending away from the support structure 532. The IC structure 502 further illustrates three gates 536 (labeled as gates 536-1, 536-2, and 536-3) enclosing the upper portion of the channel material 534, the three gates 536-1, 536-2, and 536-3 corresponding to the three metal gate lines 212 (e.g., the metal gate lines 212-5, 212-6, and 212-7, respectively) crossing the fin 104-5 in the transistor arrangement 320 of FIG. 3, with a gate spacer 540 provided on the sidewalls of the adjacent gates 536, as is known in the art. The IC structure 502 also illustrates S/D contacts 542, provided in the fin 104 between the adjacent gates 536. The support structure 532 may be implemented as the base 102, described above. The channel material 534 may be implemented as described above with reference to the channel portion of the fin 104. Each of the gates 536 may include any of the gate electrode materials as described above with reference to the gate electrode 112, e.g., the gate electrode material 536, shown in FIG. 5A, and, optionally, also a gate dielectric material as described above with reference to the gate dielectric 110 (the gate dielectric material not shown in the illustration of FIG. 5A). The gate spacer 540 may be implemented as described above with reference to the dielectric spacer that may surround the gate stack 108, i.e., it may include one or more low-k dielectric materials. The S/D contacts 542 may be implemented as described above with reference to the S/D regions 114. Methods for providing the fins 104, the gates 536 with the gate spacers 540, and the S/D contacts 542 are known in the art and, therefore, are not described here in detail.

What is different in the IC structure from other implementations of fins (or nanoribbons) with gates is that the gates 536 are only enclosed by the gate spacer 540 on their sidewalls, but there is no gate spacer 540 or any other gate cap provided over the tops of the gates 536. Such gate caps have been used in the past to reduce or eliminate the probability of the TCN2 material, provided in a later fabrication process, shorting (i.e., making an electrical connection or a short-circuit) to the gate electrode material 536 of the gates 536, e.g., if a gate spacer 538 is too thin or becomes worn out with time (because dielectric materials may break down over time, causing reliability issues). In contrast, various embodiments of the present disclosure rely on other ways to reduce or eliminate the probability of the TCN2 material shorting to the gate electrode material 536 of the gates 536, or to other components of the transistor arrangements described herein (e.g., to one or more VCGs), eliminating the need to use gate caps. Eliminating the need to use gate caps may, in turn, provide advantages, e.g., in terms of less complex/costly fabrication. In some embodiments, the gate spacers 538 and 540 may be a single/shared/common gate spacer.

The S/D contacts 542 may then be provided between the instances of the gate spacers 540 associated with adjacent gates 536. The TCN1 material 544 may then be provided above the S/D contacts 542 (e.g., to be in contact with the S/D contacts 542), in between the instances of the gate spacer 540 associated with adjacent gates 536. In this manner, the TCN1 material 544 may, advantageously, be self-aligned between the adjacent gates 536, where, in this context, "self-alignment" may mean that the TCN1 material 544 is substantially equidistant to the nearest adjacent gates 536 on different sides of the TCN material 544. A dielectric material (e.g., the ILD 546) may be provided over other portions of the IC structure, e.g., as shown on the left side of FIG. 5A.

As also shown in FIG. 5A, in some embodiments, an etch-stop material 535 may be provided, e.g., as a thin layer, between a portion of the channel material 534 of the fin and the ILD material 546. In some embodiments, the etch-stop material 535 may include materials such as silicon nitride, or silicon carbon nitride. The TCN1 material 544 may include any suitable electrically conductive material, such as one or more metals or metal alloys with metals such as copper, ruthenium, palladium, platinum, cobalt, nickel, hafnium, zirconium, titanium, tantalum, molybdenum, and aluminum. In some embodiments, the TCN1 material 544 may include one or more electrically conductive alloys, oxides (e.g., conductive metal oxides), carbides (e.g., hafnium carbide, zirconium carbide, titanium carbide, tantalum carbide, and aluminum carbide), or nitrides (e.g. hafnium nitride, zirconium nitride, titanium nitride, tantalum nitride, and aluminum nitride) of one or more metals.

Performing gate and TCN1 patterning in the process 402 may include using any suitable patterning techniques to define the locations and the dimensions of the gates 536 and the TCN2 material 544, such as, but not limited to, photolithographic or electron-beam (e-beam) patterning, possibly in conjunction with the use of one or more masks. Various dielectric materials as described herein, e.g., the gate spacer 540 and/or the ILD 546, may be deposited using any suitable deposition technique such as spin-coating, dip-coating, physical vapor deposition (PVD) (e.g., evaporative deposition, magnetron sputtering, or e-beam deposition), or chemical vapor deposition (CVD). Various conductive materials as described herein, e.g., the TCN1 material 544, may be deposited using any suitable deposition technique such as PVD, CVD, or atomic layer deposition (ALD). The process 402 may also include using any suitable polishing techniques such as CMP to ensure that the upper surfaces of the TCN1 material 544 may be flush with the upper surfaces of the gates 536 and with the upper surfaces of the gate spacers 538 and 540. The etch-stop material 535 may be deposited using any suitable deposition technique such as ALD, CVD, etc.

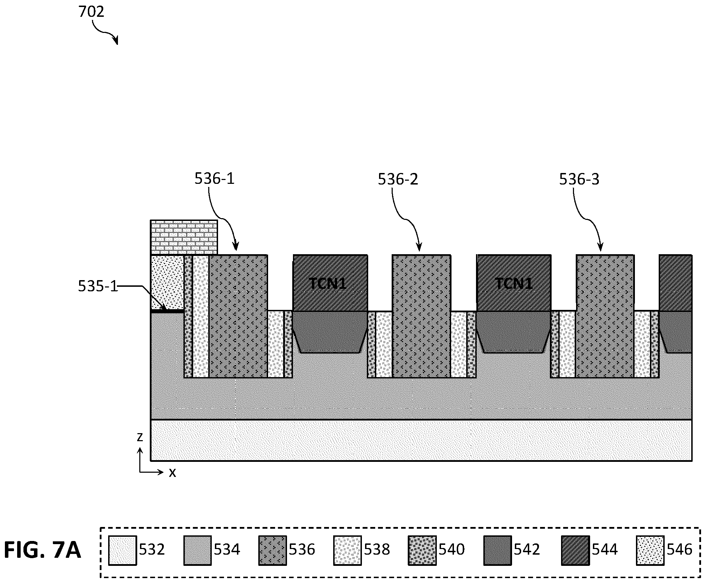

The method 400 may then proceed with a process 404, in which an etch-stop layer (ESL) and a stack of a sacrificial material and a sacrificial etch cap are provided over the IC structure formed in the previous process, e.g., over the IC structure 502 formed in the process 402 (or, for the embodiments shown in FIGS. 7A-7B, provided over the IC structure 704). An example result of the process 404 is illustrated with an IC structure 504, shown in FIG. 5B, where a new layer of the etch-stop material 535 (labeled as "535-2") is illustrated to be provided over all upper surfaces of the IC structure 502 of FIG. 5A, then a sacrificial material 548 is provided over the etch-stop material 535-2, following by a sacrificial etch cap 550 are provided over the sacrificial material 548, thus forming a stack 537. In some embodiments, the sacrificial etch cap 550 may be any suitable material that is sufficiently etch-selective with respect to the sacrificial material 548, so that, in a later fabrication process (e.g., in the process 406, described below), the sacrificial etch cap 550 may be patterned and then used as a mask to form openings in the sacrificial material 548. In some embodiments, the sacrificial material 548 may be any suitable material that is sufficiently etch-selective with respect to the material of the ESL 535-2, so that, in a later fabrication process (e.g., in the process 406, described below), the sacrificial material 548 may be etched without substantially etching the ESL 535-2. In some embodiments, the sacrificial material 548 may include materials such as amorphous silicon, while the sacrificial etch cap 550 may include materials such as silicon nitride or silicon carbon nitride (e.g., in some embodiments, the sacrificial etch cap 550 and any of the ESLs 535 may have similar or substantially the same material composition). In various embodiments, the sacrificial material 548 and the sacrificial etch cap 550 may be deposited using any suitable deposition technique such as spin-coating, dip-coating, PVD, or CVD.

Next, the method 400 may proceed with a process 406, which includes patterning the stack of the sacrificial material and the sacrificial etch cap provided in the process 404 to form replacement TCN2 structures (e.g., pillars). An example result of the process 406 is illustrated with an IC structure 506, shown in FIG. 5C. FIG. 5C illustrates openings 539 formed in the stack 537 substantially above the gates 536 so that replacement TCN2 pillars 541 may be formed substantially above the TCN1 material 544 between different pairs of adjacent gates 536. In some embodiments, the process 406 may include performing an anisotropic etch (e.g., reactive dry etch), possibly using a sequence of different etchants, to selectively etch through the sacrificial etch cap 550 above the sacrificial material 548, then through the sacrificial material 548, stopping at the ESL 535-2 (e.g., the etch of the process 406 may be etch-selective with respect to ESL 535-2).

In some embodiments, the anisotropic etch of any of the processes of the method 400 may include an etch that uses etchants in a form of e.g., chemically active ionized gas (i.e., plasma) using e.g., bromine (Br) and chloride (CI) based chemistries. In some embodiments, during the anisotropic etch of any of the processes of the method 400, the IC structure may be heated to elevated temperatures, e.g., to temperatures between about room temperature and 200 degrees Celsius, including all values and ranges therein, to promote that byproducts of the etch are made sufficiently volatile to be removed from the surface. In some embodiments, the anisotropic etch of any of the processes of the method 400 may include a dry etch, such as radio frequency (RF) reactive ion etch (RIE) or inductively coupled plasma (ICP) RIE. Although not specifically shown in the present drawings, in various embodiments, any suitable patterning techniques may be before performing the anisotropic etch of any of the processes of the method 400 to define the locations and the dimensions of the openings to be etched.

Because of the subtractive fabrication used to form the openings 539, these openings may have taper shapes that have their narrow ends at the bottoms of the openings 539 (i.e., at the ends of the openings 539 that are closer to the support structure 523). Therefore, the replacement TCN2 pillars 541 may have inverse taper shapes that have their narrow ends at the tops of the replacement TCN2 pillars 541 (i.e., at the ends of the replacement TCN2 pillars 541 that are further away from the support structure 523), as can be seen in FIG. 5C. Thus, for each of the replacement TCN2 pillars 541, the width of the pillar 541 (a dimension measured along the x-axis of the example coordinate system shown in FIG. 5) at a first distance from the support structure 532 or from the respective S/D contact 542 (e.g., the width of the pillar 541 at the bottom of the pillar 541) may be greater, e.g., at least about 1 nm greater, than the width of the pillar 541 at a second distance from the support structure 532 or from the respective S/D contact 542 (e.g., the width of the pillar 541 at the top of the pillar 541), the second distance being greater than the first distance.

Ideally, it may be desirable to provide the opening 539 so that they are directly over and aligned with the gate spacer 540 at the bottom of the openings 539 so that the bottoms of the replacement TCN2 pillars 541 are aligned with the TCN1 material 544 directly under each of the replacement TCN2 pillars 541, e.g., using a suitable mask. However, such alignment may be difficult to achieve in practice. Therefore, FIG. 5C illustrates a result of performing the process 406 with the opening 539 being somewhat misaligned so that the bottom of each of the replacement TCN2 pillars 541 may be smaller than the TCN1 material 544 directly under the respective one of the replacement TCN2 pillars 541. It should also be noted that FIG. 5C and the subsequent drawings illustrate the bottoms of the replacement TCN2 pillars 541 being substantially centered around the center of the respective TCN1 materials 544 underneath. However, this does not have to be so in other embodiments because the replacement TCN2 pillars 541 are not self-aligned with respect to the regions of the TCN1 material 544. Therefore, in general, each of the replacement TCN2 pillars 541 may be slightly shifted to the left or to the right of the view of the IC structure 506 in other embodiments, as long as the openings 539 are formed so that the bottoms of the replacement TCN2 pillars 541 do not overlap with the gate electrode material 536.

The method 400 may then proceed with a process 408 that includes providing a spacer material around sidewalls of the replacement TCN2 pillars 541 formed in the process 406. An example result of the process 408 is illustrated with an IC structure 508, shown in FIG. 5D, where a spacer 552 is shown over the sidewalls of the replacement TCN2 pillars 541 (hence, the spacer 552 may be referred to as a "TCN2 spacer" 552). In some embodiments, the TCN2 spacer 552 may be any suitable material that is sufficiently etch-selective with respect to the sacrificial material 548, so that, in a later fabrication process (e.g., in the process 412, described below), the sacrificial material 548 may be etched without substantially etching the TCN2 spacer 552. In some embodiments, the TCN2 spacer 552 may include a material having a higher dielectric constant than typical materials used as interlayer dielectrics (i.e., low-k dielectrics or silicon oxide). Some examples of materials that may be used as the TCN2 spacer 552 include silicon nitride or silicon oxycarbon nitride (e.g., in some embodiments, the TCN2 spacer 552 and any of the sacrificial etch cap 550 and any of the ESLs 535 may have similar or substantially the same material composition). In various embodiments, the TCN2 spacer 552 may be deposited using any suitable deposition technique such as PVD, or CVD, possibly in combination with any suitable RIE technique.

The method 400 may then proceed with a process 410 that includes depositing a dielectric material over the result of the process 408 and then polishing the structure, e.g., to expose the top surfaces of the sacrificial material 548 of the replacement TCN2 pillars 541. An example result of the process 410 is illustrated with an IC structure 510, shown in FIG. 5E, illustrating the ILD 546 deposited around the replacement TCN2 pillars 541 and further illustrating that the ILD 546 and the replacement TCN2 pillars 541 are polished/planarized to expose the sacrificial material 548 of the replacement TCN2 pillars 541. The process 410 may include polishing to expose the sacrificial material 548 as shown in FIG. 5E (i.e., the sacrificial etch cap 550 is polished away) so that it may be easily removed in a subsequent fabrication process (e.g., in the process 412, described above) using etchants that can etch the sacrificial material 548 without substantially etching the TCN2 spacer 552. However, in other embodiments of the process 410 (not shown in the present drawings), polishing may be performed to expose the sacrificial etch cap 550 that may be thinned but is not completely removed in the process 410. Such embodiments may be used if the TCN2 spacer 552 has substantially the same etch rate or is sufficiently etch-selective with respect to the sacrificial etch cap 550 so that the remaining sacrificial etch cap 550 may be removed in a subsequent fabrication process (e.g., in the process 412, described above) using etchants that can etch the sacrificial etch cap 550 without substantially etching the TCN2 spacer 552 more than the etch cap 550, after which the sacrificial material 548 may be removed.

While FIG. 5E illustrates that the ILD 546 is deposited in the process 410, in various embodiments, material compositions of the ILD 546 deposited in the process 410 and the ILD 546 provided in the process 402 as well as in other portions of the IC structures or transistor arrangements described herein, may, but do not have to be, the same.

Next, the method 400 may proceed with a process 412, which includes removing all materials of the replacement TCN2 pillars and breaking through the ESL 535-2 to expose the TCN1 material 544 that was underneath the pillars. An example result of the process 412 is illustrated with an IC structure 512, shown in FIG. 5F. FIG. 5F illustrates openings 545 formed where the sacrificial material 548 (and, possibly, at least a portion of the sacrificial etch cap 550, depending on how the polishing of the process 410 was done, as described above) used to be. In some embodiments, the process 412 may include performing a first etch, e.g., a first anisotropic etch (e.g., reactive dry etch), possibly using a sequence of different etchants, to selectively etch through the sacrificial etch cap 550, if any was remaining above the sacrificial material 548 after the process 410, then through the sacrificial material 548 of the replacement TCN2 pillars 541, stopping at the ESL 535-2 (e.g., the etch of the sacrificial material 548 of the process 412 may be etch-selective with respect to ESL 535-2). The process 412 may further include an additional etch to remove the portions of the ESL 535-2 that were exposed by the first etch (i.e., to remove the portions of the ESL 535-2 that were at the bottoms of the pillars 541). As a result, openings 545 are formed in places of the pillars 541, as illustrated in FIG. 5F. Because the TCN2 spacer 552 is sufficiently etch-equivalent or etch-selective with respect to the sacrificial material 548 of the pillars 541, the TCN2 spacer 552 may substantially remain, enclosing the openings 545. The openings 545 define locations and dimensions of future TCN2.

The method 400 may then proceed with a process 414 that includes filling the openings formed in the process 412 with an electrically conductive material for the TCN2. An example result of the process 414 is illustrated with an IC structure 514, shown in FIG. 5G, showing openings 545-1 through 545-3 being filled with a TCN2 material 554. In various embodiments, the TCN2 material 554 may include any of the electrically conductive materials described above, and may, but does not have to, have the same material composition as the TCN1 material 544.

By virtue of the openings 545 breaking through the ESL 535-2, once these openings are filled with the TCN2 material 554, an electrical connection is made between the TCN2 material 554 and the TCN1 material 544 underneath, thus providing electrical coupling between the TCN2 material 554 and the corresponding S/D contact 542 underneath. For example, a portion of the TCN2 material 554 in the opening 545-1 forms a trench contact TCN2 to the S/D contact 542 between the gates 536-1 and 536-2, via a portion of the TCN1 material 544 that forms the trench contact TCN1 between the gates 536-1 and 536-2. Similarly, a portion of the TCN2 material 554 in the opening 545-2 forms a trench contact TCN2 to the S/D contact 542 between the gates 536-2 and 536-3, via a portion of the TCN1 material 544 that forms the trench contact TCN1 between the gates 536-2 and 536-3, and so on. Trench contacts TCN1 and TCN2 are labeled in FIG. 5G. Thus, FIG. 5G illustrates two instances of stacked trench contacts: one is a stack of trench contacts TCN1 and TCN2 to electrically couple to the S/D contact 542 between the gates 536-1 and 536-2 and another stack of trench contacts TCN1 and TCN2 is to electrically couple to the S/D contact 542 between the gates 536-2 and 536-3.

The method 400 may also include a process 416, in which gate vias may be provided in the dielectric material between the spacers of adjacent TCN2. An example result of the process 416 is illustrated with an IC structure 516, shown in FIG. 5H, illustrating that a gate via (VCG) may be provided over the gate 536-2 and another VCG may be provided over the gate 536-3. A top-down view of the IC structure 516 is shown as the transistor arrangement 320 of FIG. 3.

In order to form a VCG, the process 416 may include etching an opening in the dielectric material between the spacers of adjacent TCN2 (e.g., in the ILD 546, shown in FIG. 5H), breaking through the ESL 535-2 to expose a portion of the gate electrode material 536 exposed by the opening in the dielectric material (e.g., using any of the processes for removing dielectric materials and the ESL 535-2, described above), and then filling the opening with a VCG material 556 (e.g., using any of the deposition processes for depositing electrically conductive materials, described above). The VCG material 556 may include any of the electrically conductive materials described with reference to the TCN1 material 544 and/or the TCN2 material 554. By being an electrically conductive material, the VCG material 556 may form a gate contact VCG. FIG. 5H illustrates two instances of VCG: one providing a gate contact to the gate 536-2 and another one providing a gate contact to the gate 536-3, although in other embodiments one of more of these gate contacts may be absent. As can be seen in FIG. 5H, the taper shape of the VCGs is opposite to that of the TCN2. This may advantageously increase distance between the TCN2 and adjacent VCG, increase the edge placement error margin, decrease the probability of an unintended short-circuit between the TCN2 and the adjacent VCG, and decrease the probability of a dielectric breakdown between the TCN2 and the adjacent VCG.

### Additions and alternatives to the example fabrication method

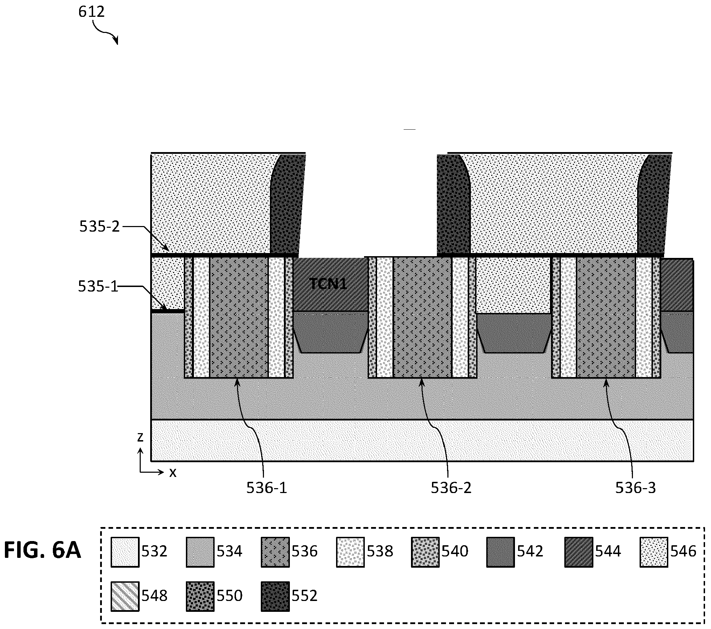

As described above, the number and the nature of various components of the IC structures shown in the present drawings, e.g., the number and the nature of various trench and gate contacts in FIGS. 5A-5H, are purely illustrative. In fact, the fabrication method 400 is highly versatile to allow forming other combinations of trench and gate contacts, as may be desired for other designs. For example, in case the design of a transistor arrangement is such that a gate of a transistor is to be coupled to a S/D contact of the transistor (e.g., for the optional embodiments of gate-to-S/D coupling for one of the transistors of the IC structures described herein), the method 400 may be modified as illustrated in FIGS. 6A-6C. FIGS. 6A-6C are cross-sectional side views illustrating different example stages in the manufacture of an alternative transistor arrangement with one or more stacked trench contacts and one or more gate contacts without gate caps using the method of FIG. 4, according to some embodiments of the present disclosure.

An IC structure 612, shown in FIG. 6A, is an example result of extending the process 412 to not only remove materials of the replacement TCN2 pillars 541, thus forming the openings 545 as described above, but also extending at least one of the openings 545 to also expose at least a portion of the gate electrode material 536 of one of the transistors. In FIG. 6A this extension of one of the openings 545 is shown for an opening 645-1, which is similar to the opening 545-1 of the IC structure 512 of FIG. 5F, in that it exposes some or all of the TCN1 material 544 between the gates 536-1 and 536-2 but is extended further (including breaking through the ESL 535-2) to also expose some or all of the gate electrode material 536 of the gate 536-2. Such an extension of the opening 545-1 to realize the opening 645-1 may, e.g., be done using lithography to define an additional area to etch besides the sacrificial material 548. This is where the lack of gate cap over the gates 536, e.g., over the gate 536-2 for the example shown, is particularly helpful to easily extending the design to create a gate-to-S/D coupling without the need to use complicated masks and/or additional fabrication processes. The openings 645-2 and 645-3 in the IC structure 612 may be substantially the same as the openings 545-2 and 545-3 in the IC structure 512 of FIG. 5F.

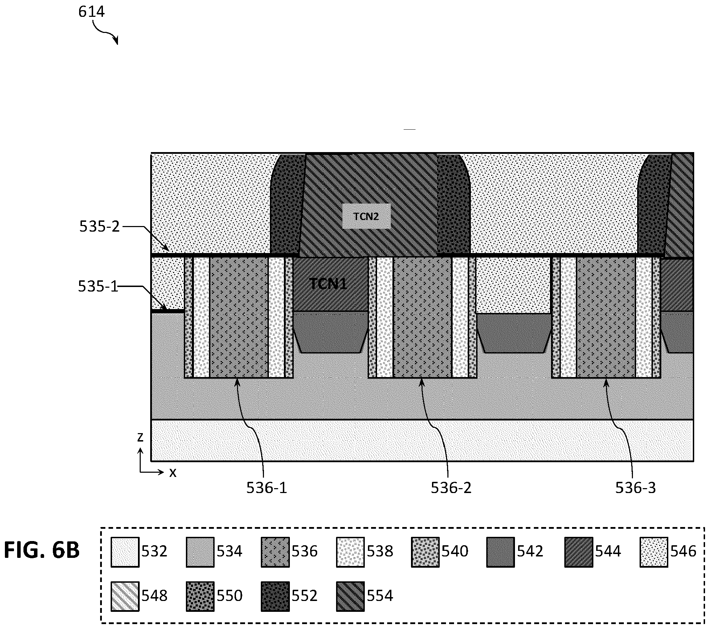

An IC structure 614, shown in FIG. 6B, is an example result of extending the process 414, where the openings 645 are filled with the TCN2 material 554, as described above. By virtue of the opening 645-1 of the IC structure 612 breaking through the ESL 535-2 to expose, at least partially, both the TCN material 544 between the gates 536-1 and 536-2 and the gate electrode material 536 of the gate 536-2, once this opening is filled with the TCN2 material 554, an electrical connection is made between the TCN2 material 554 and the TCN1 material 544 underneath, as well as between the TCN2 material 554 and the gate electrode material 536 of the gate 536-2, thus providing electrical coupling, via the TCN2 material 554, between the S/D contact 542 between the gates 536-1 and 536-2 and the gate 536-2.

An IC structure 616, shown in FIG. 6C, is an example result of extending the process 416, in which gate vias may be provided in the dielectric material between the spacers of adjacent TCN2, as described above. FIG. 6C illustrates one instance of VCG: one providing a gate contact to the gate 536-3, although in other embodiments other gate contact arrangements may be implemented. A top-down view of the IC structure 616 is shown as the transistor arrangement 322 of FIG. 3.

Another possible addition to the method 400 is shown in FIGS. 7A-7B, providing cross-sectional side views illustrating different example stages in the manufacture of an alternative transistor arrangement with one or more stacked trench contacts and one or more gate contacts without gate caps that could be implemented additional to the method 400, according to some embodiments of the present disclosure.

An IC structure 702, shown in FIG. 7A, is an example result of implementing an additional process, after the process 402 of the method 400, to recess portions of the gate spacer 540. As depicted in FIG. 7A, in some embodiments, a mask 732 may be used to define locations where it is desirable to recess portions of the gate spacer 540 of one or more gates 536. The IC structure 702 illustrates an example of forming recesses 745 (labeled as recesses 745-1 through 745-5). In some embodiments, the recesses 745 may be formed using any suitable etch-selective process that etches the dielectric material of the gate spacer 540 without substantially etching the electrically conductive material of the TCN1 material 544 and the gate electrode material 536, since conductive materials and dielectric materials are typically sufficiently etch-selective. In a maskless process, the etch-selective process would etch the spacer dielectric materials with selectivity to the ILD and the gate and TCN metals.

Although the recesses 745 appear to be aligned with the bottom of the TCN1 material 544, this does not have to be the same in other embodiments of the IC structure 702. In particular, if the recesses 745 are formed using a timed isotropic etch (e.g., a wet etch or remote plasma etch) to remove the gate spacer 540 without substantially removing other materials of the IC structure 702 (e.g., using etchants that may remove dielectric materials without substantially removing electrically conductive materials), the depth of the recesses 745 may be difficult to control. Therefore, in other embodiments, the recesses 745 may be such that all of the gate spacer 540 is removed in the recesses 745, and, in some embodiments, the recesses 745 may even extend into the channel material 534 below the gate spacers 540.

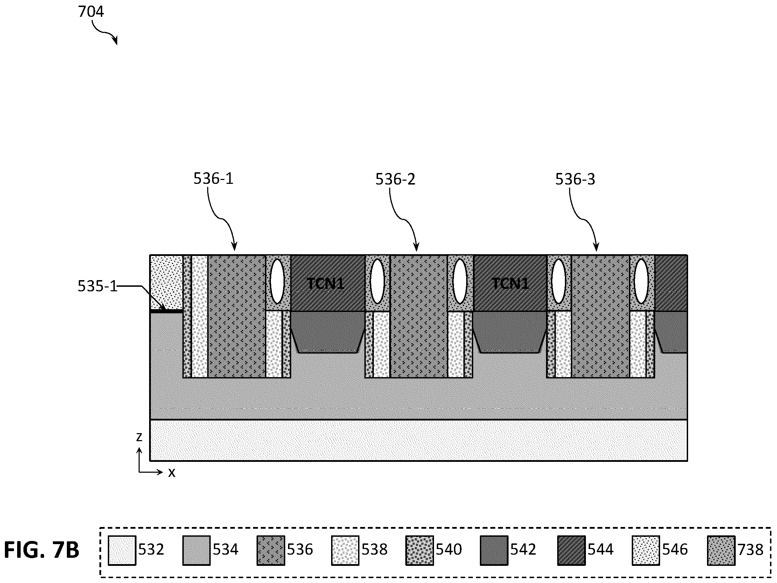

Exact control of the depth of the recesses 745 is not necessary because in a subsequent process the recesses 745 may be re-filled with an insulating material. An IC structure 704, shown in FIG. 7B, is an example result of implementing an additional process, after the process of FIG. 7A, to at least partially re-fill the recesses 745 of the IC structure 702. FIG. 7B illustrates the recesses 745 re-filled with a replacement gate spacer material 738, which may include any of the materials described with reference to the gate spacer 540, and may, but does not have to, have substantially the same material composition as that of the gate spacer 540. In various embodiments, the replacement gate spacer material 738 may be deposited using any suitable deposition technique such CVD or ALD, possibly in combination with any suitable etchback technique for multiple cycles. Because the recesses 745 are relatively high-AR openings, re-filling them with the replacement gate spacer material 738 may result in formation of voids 750, only one of which is labeled in FIG. 7B with a reference numeral "750" although FIG. 7B illustrates all of the recesses 745 re-filled with the replacement gate spacer material 738 to include such a void. In some embodiments, each of the voids 750 may be substantially in the center of each re-filled recess 745. Such voids may advantageously decrease capacitance between adjacent gates 938 and the TCN1 material 544, e.g., decrease by about 10%-20% gate to contact capacitance. After this process, the method 400 may continue with the process 404 as described above.

While FIG. 7 illustrates the use of providing voids 750 in the recesses of the gate spacer 540 implemented in transistor arrangements fabricated using the method 400, in other embodiments, such voids may be used in IC structures where trench and gate contacts are formed using any fabrication method besides the method 400. In other words, in other embodiments, transistor arrangements with voids provided in re-filled recesses of a gate spacer may be implemented without implementing the stacked trench contacts and gate contacts without the gate cap in the manner described herein (e.g., such voids may be combined with any conventional ways to provide trench and gate contacts).

### Variations and implementations

The IC structures illustrated in and described with reference to FIGS. 1-7 do not represent an exhaustive set of assemblies in which transistor arrangements with one or more stacked trench contacts and/or one or more gate contacts without gate caps as described herein may be integrated, but merely provide examples of such arrangements. For example, while descriptions and drawings provided herein refer to FinFETs, these descriptions and drawings are equally applicable to embodiments any other non-planar FETs besides FinFETs that are formed on the basis of an elongated structure of a suitable channel material, e.g., to nanoribbon transistors, nanowire transistors, or transistors such as nanoribbon/nanowire transistors but having transverse cross-sections of any geometry (e.g., oval, or a polygon with rounded corners). In another example, although particular arrangements of materials are discussed with reference to FIGS. 1-7, intermediate materials may be included in various portions of these drawings. Additionally, while FIGS. 1-7 may illustrate various elements, e.g., the gate electrode material 536 of the gates 536, etc., as having perfectly straight sidewall profiles, i.e., profiles where the sidewalls extend perpendicularly to the support structure 532, these idealistic profiles may not always be achievable in real-world manufacturing processes. Namely, while designed to have straight sidewall profiles, real-world openings which may be formed as a part of fabricating various elements of the transistor arrangements illustrated in FIGS. 1-7 may end up having either so-called "non-re-entrant" profiles, where the width at the top of the opening is larger than the width at the bottom of the opening, or "re-entrant" profiles, where the width at the top of the opening is smaller than the width at the bottom of the opening. Oftentimes, as a result of a real-world opening not having perfectly straight sidewalls, imperfections may form within the materials filling the opening. For example, typical for re-entrant profiles, a void may be formed in the center of the opening, where the growth of a given material filling the opening pinches off at the top of the opening. Therefore, descriptions of various embodiments of transistor arrangements with one or more stacked trench contacts and/or one or more gate contacts without gate caps as provided herein are equally applicable to embodiments where various elements of IC structures including such transistor arrangements look different from those shown in the drawings due to manufacturing processes used to form them.

### Example electronic devices

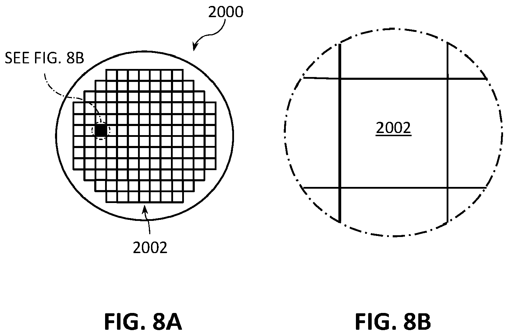

The IC structures with transistor arrangements with one or more stacked trench contacts and/or one or more gate contacts without gate caps, disclosed herein, may be included in any suitable electronic device. For example, in various embodiments, any of the IC structures or the transistor arrangements described herein may be a part of at least one of a memory device, a computing device, a wearable device, a handheld electronic device, and a wireless communications device. FIGS. 8-11 illustrate various examples of apparatuses that may include one or more of the transistor arrangements with one or more stacked trench contacts and/or one or more gate contacts without gate caps disclosed herein.

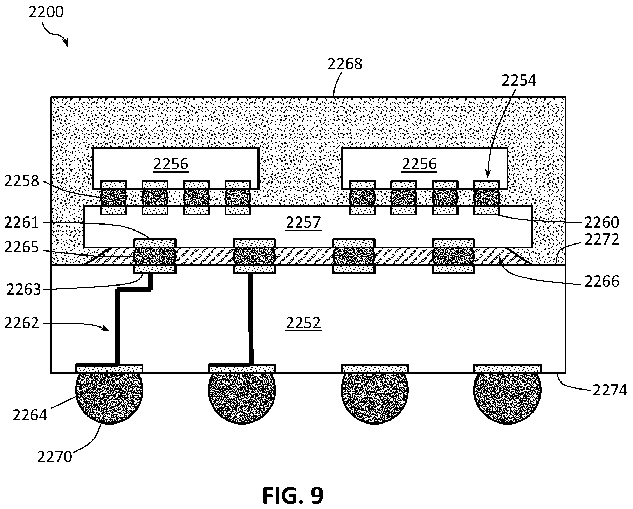

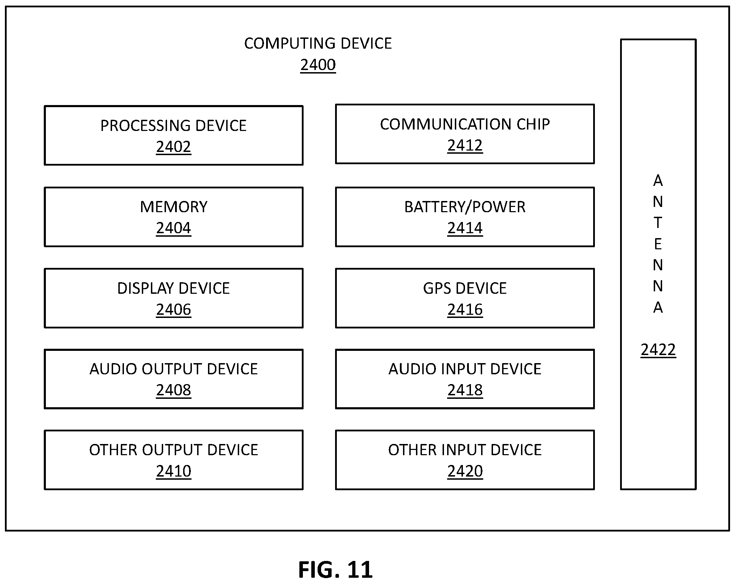

FIGS. 8A-8B are top views of a wafer 2000 and dies 2002 that may include one or more IC structures with one or more transistor arrangements with one or more stacked trench contacts and/or one or more gate contacts without gate caps in accordance with any of the embodiments disclosed herein. In some embodiments, the dies 2002 may be included in an IC package, in accordance with any of the embodiments disclosed herein. For example, any of the dies 2002 may serve as any of the dies 2256 in an IC package 2200 shown in FIG. 9. The wafer 2000 may be composed of semiconductor material and may include one or more dies 2002 having IC structures formed on a surface of the wafer 2000. Each of the dies 2002 may be a repeating unit of a semiconductor product that includes any suitable IC (e.g., ICs including one or more transistor arrangements with one or more stacked trench contacts and/or one or more gate contacts without gate caps as described herein). After the fabrication of the semiconductor product is complete (e.g., after manufacture of one or more layers of an IC structure with at least one transistor arrangement with one or more stacked trench contacts and/or one or more gate contacts without gate caps as described herein), the wafer 2000 may undergo a singulation process in which each of the dies 2002 is separated from one another to provide discrete "chips" of the semiconductor product. In particular, devices that include one or more transistor arrangements with one or more stacked trench contacts and/or one or more gate contacts without gate caps as disclosed herein may take the form of the wafer 2000 (e.g., not singulated) or the form of the die 2002 (e.g., singulated). The die 2002 may include supporting circuitry to route electrical signals to various memory cells, transistors, capacitors, as well as any other IC components. In some embodiments, the wafer 2000 or the die 2002 may implement or include a memory device (e.g., a static RAM (SRAM) device), a logic device (e.g., an AND, OR, NAND, or NOR gate), or any other suitable circuit element. Multiple ones of these devices may be combined on a single die 2002. For example, a memory array formed by multiple memory devices may be formed on a same die 2002 as a processing device (e.g., the processing device 2402 of FIG. 11) or other logic that is configured to store information in the memory devices or execute instructions stored in the memory array.

FIG. 9 is a side, cross-sectional view of an example IC package 2200 that may include one or more transistor arrangements with one or more stacked trench contacts and/or one or more gate contacts without gate caps in accordance with any of the embodiments disclosed herein. In some embodiments, the IC package 2200 may be a system-in-package (SiP).

The package substrate 2252 may be formed of a dielectric material (e.g., a ceramic, a buildup film, an epoxy film having filler particles therein, etc.), and may have conductive pathways extending through the dielectric material between the face 2272 and the face 2274, or between different locations on the face 2272, and/or between different locations on the face 2274.

The package substrate 2252 may include conductive contacts 2263 that are coupled to conductive pathways 2262 through the package substrate 2252, allowing circuitry within the dies 2256 and/or the interposer 2257 to electrically couple to various ones of the conductive contacts 2264 (or to other devices included in the package substrate 2252, not shown).

The IC package 2200 may include an interposer 2257 coupled to the package substrate 2252 via conductive contacts 2261 of the interposer 2257, first-level interconnects 2265, and the conductive contacts 2263 of the package substrate 2252. The first-level interconnects 2265 illustrated in FIG. 9 are solder bumps, but any suitable first-level interconnects 2265 may be used. In some embodiments, no interposer 2257 may be included in the IC package 2200; instead, the dies 2256 may be coupled directly to the conductive contacts 2263 at the face 2272 by first-level interconnects 2265.

The IC package 2200 may include one or more dies 2256 coupled to the interposer 2257 via conductive contacts 2254 of the dies 2256, first-level interconnects 2258, and conductive contacts 2260 of the interposer 2257. The conductive contacts 2260 may be coupled to conductive pathways (not shown) through the interposer 2257, allowing circuitry within the dies 2256 to electrically couple to various ones of the conductive contacts 2261 (or to other devices included in the interposer 2257, not shown). The first-level interconnects 2258 illustrated in FIG. 9 are solder bumps, but any suitable first-level interconnects 2258 may be used. As used herein, a "conductive contact" may refer to a portion of electrically conductive material (e.g., metal) serving as an interface between different components; conductive contacts may be recessed in, flush with, or extending away from a surface of a component, and may take any suitable form (e.g., a conductive pad or socket).

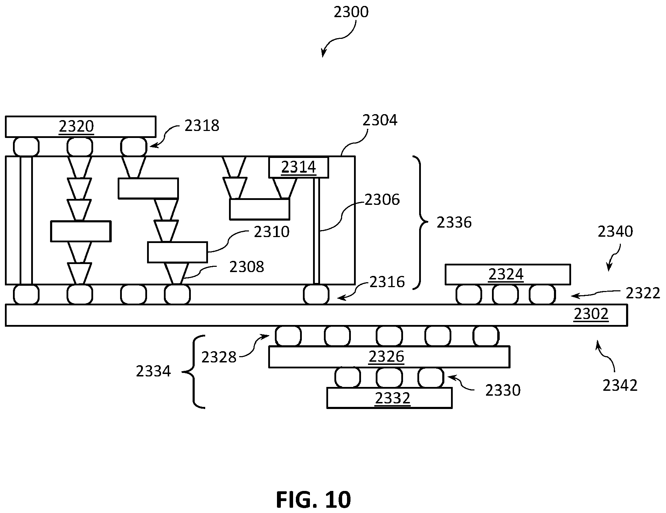

In some embodiments, an underfill material 2266 may be disposed between the package substrate 2252 and the interposer 2257 around the first-level interconnects 2265, and a mold compound 2268 may be disposed around the dies 2256 and the interposer 2257 and in contact with the package substrate 2252. In some embodiments, the underfill material 2266 may be the same as the mold compound 2268. Example materials that may be used for the underfill material 2266 and the mold compound 2268 are epoxy mold materials, as suitable. Second-level interconnects 2270 may be coupled to the conductive contacts 2264. The second-level interconnects 2270 illustrated in FIG. 9 are solder balls (e.g., for a ball grid array arrangement), but any suitable second-level interconnects 2270 may be used (e.g., pins in a pin grid array arrangement or lands in a land grid array arrangement). The second-level interconnects 2270 may be used to couple the IC package 2200 to another component, such as a circuit board (e.g., a motherboard), an interposer, or another IC package, as known in the art and as discussed below with reference to FIG. 10.

The dies 2256 may take the form of any of the embodiments of the die 2002 discussed herein (e.g., may include any of the embodiments of the IC structures with transistor arrangements with one or more stacked trench contacts and/or one or more gate contacts without gate caps as described herein). In embodiments in which the IC package 2200 includes multiple dies 2256, the IC package 2200 may be referred to as a multi-chip package (MCP). The dies 2256 may include circuitry to perform any desired functionality. For example, one or more of the dies 2256 may be logic dies (e.g., silicon-based dies), and one or more of the dies 2256 may be memory dies (e.g., high bandwidth memory). In some embodiments, any of the dies 2256 may include one or more IC structures with one or more transistor arrangements with one or more stacked trench contacts and/or one or more gate contacts without gate caps as discussed above; in some embodiments, at least some of the dies 2256 may not include any transistor arrangements with one or more stacked trench contacts and/or one or more gate contacts without gate caps.

The IC package 2200 illustrated in FIG. 9 may be a flip chip package, although other package architectures may be used. For example, the IC package 2200 may be a ball grid array (BGA) package, such as an embedded wafer-level ball grid array (eWLB) package. In another example, the IC package 2200 may be a wafer-level chip scale package (WLCSP) or a panel fan-out (FO) package. Although two dies 2256 are illustrated in the IC package 2200 of FIG. 9, an IC package 2200 may include any desired number of the dies 2256. An IC package 2200 may include additional passive components, such as surface-mount resistors, capacitors, and inductors disposed on the first face 2272 or the second face 2274 of the package substrate 2252, or on either face of the interposer 2257. More generally, an IC package 2200 may include any other active or passive components known in the art.

FIG. 10 is a cross-sectional side view of an IC device assembly 2300 that may include components having one or more transistor arrangements with one or more stacked trench contacts and/or one or more gate contacts without gate caps in accordance with any of the embodiments disclosed herein. The IC device assembly 2300 includes a number of components disposed on a circuit board 2302 (which may be, e.g., a motherboard). The IC device assembly 2300 includes components disposed on a first face 2340 of the circuit board 2302 and an opposing second face 2342 of the circuit board 2302; generally, components may be disposed on one or both faces 2340 and 2342. In particular, any suitable ones of the components of the IC device assembly 2300 may include any of one or more IC structures with one or more transistor arrangements with one or more stacked trench contacts and/or one or more gate contacts without gate caps in accordance with any of the embodiments disclosed herein; e.g., any of the IC packages discussed below with reference to the IC device assembly 2300 may take the form of any of the embodiments of the IC package 2200 discussed above with reference to FIG. 9 (e.g., may include one or more transistor arrangements with one or more stacked trench contacts and/or one or more gate contacts without gate caps provided on a die 2256).

In some embodiments, the circuit board 2302 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 2302. In other embodiments, the circuit board 2302 may be a non-PCB substrate.

The IC device assembly 2300 illustrated in FIG. 10 includes a package-on-interposer structure 2336 coupled to the first face 2340 of the circuit board 2302 by coupling components 2316. The coupling components 2316 may electrically and mechanically couple the package-on-interposer structure 2336 to the circuit board 2302, and may include solder balls (e.g., as shown in FIG. 10), male and female portions of a socket, an adhesive, an underfill material, and/or any other suitable electrical and/or mechanical coupling structure.

The package-on-interposer structure 2336 may include an IC package 2320 coupled to an interposer 2304 by coupling components 2318. The coupling components 2318 may take any suitable form for the application, such as the forms discussed above with reference to the coupling components 2316. The IC package 2320 may be or include, for example, a die (the die 2002 of FIG. 8B), an IC device, or any other suitable component. In particular, the IC package 2320 may include one or more transistor arrangements with one or more stacked trench contacts and/or one or more gate contacts without gate caps as described herein. Although a single IC package 2320 is shown in FIG. 10, multiple IC packages may be coupled to the interposer 2304; indeed, additional interposers may be coupled to the interposer 2304. The interposer 2304 may provide an intervening substrate used to bridge the circuit board 2302 and the IC package 2320. Generally, the interposer 2304 may spread a connection to a wider pitch or reroute a connection to a different connection. For example, the interposer 2304 may couple the IC package 2320 (e.g., a die) to a BGA of the coupling components 2316 for coupling to the circuit board 2302. In the embodiment illustrated in FIG. 10, the IC package 2320 and the circuit board 2302 are attached to opposing sides of the interposer 2304; in other embodiments, the IC package 2320 and the circuit board 2302 may be attached to a same side of the interposer 2304. In some embodiments, three or more components may be interconnected by way of the interposer 2304.

The interposer 2304 may be formed of an epoxy resin, a fiberglass-reinforced epoxy resin, a ceramic material, or a polymer material such as polyimide. In some implementations, the interposer 2304 may be formed of alternate rigid or flexible materials that may include the same materials described above for use in a semiconductor substrate, such as silicon, germanium, and other group III-V and group IV materials. The interposer 2304 may include any number of metal lines 2310, vias 2308, and through-silicon vias (TSVs) 2306. The interposer 2304 may further include embedded devices 2314, including both passive and active devices. Such devices may include, but are not limited to, capacitors, decoupling capacitors, resistors, inductors, fuses, diodes, transformers, sensors, electrostatic discharge (ESD) protection devices, and memory devices. More complex devices such as RF devices, power amplifiers, power management devices, antennas, arrays, sensors, and microelectromechanical systems (MEMS) devices may also be formed on the interposer 2304. The package-on-interposer structure 2336 may take the form of any of the package-on-interposer structures known in the art.

The IC device assembly 2300 may include an IC package 2324 coupled to the first face 2340 of the circuit board 2302 by coupling components 2322. The coupling components 2322 may take the form of any of the embodiments discussed above with reference to the coupling components 2316, and the IC package 2324 may take the form of any of the embodiments discussed above with reference to the IC package 2320.

The IC device assembly 2300 illustrated in FIG. 10 includes a package-on-package structure 2334 coupled to the second face 2342 of the circuit board 2302 by coupling components 2328. The package-on-package structure 2334 may include an IC package 2326 and an IC package 2332 coupled together by coupling components 2330 such that the IC package 2326 is disposed between the circuit board 2302 and the IC package 2332. The coupling components 2328 and 2330 may take the form of any of the embodiments of the coupling components 2316 discussed above, and the IC packages 2326 and 2332 may take the form of any of the embodiments of the IC package 2320 discussed above. The package-on-package structure 2334 may be configured in accordance with any of the package-on-package structures known in the art.

FIG. 11 is a block diagram of an example computing device 2400 that may include one or more components with one or more transistor arrangements with one or more stacked trench contacts and/or one or more gate contacts without gate caps in accordance with any of the embodiments disclosed herein. For example, any suitable ones of the components of the computing device 2400 may include a die (e.g., the die 2002, shown in FIG. 8B) implementing transistor arrangements with one or more stacked trench contacts and/or one or more gate contacts without gate caps in accordance with any of the embodiments disclosed herein. Any of the components of the computing device 2400 may include an IC package 2200 (e.g., as shown in FIG. 9). Any of the components of the computing device 2400 may include an IC device assembly 2300 (e.g., as shown in FIG. 10).

A number of components are illustrated in FIG. 11 as included in the computing device 2400, but any one or more of these components may be omitted or duplicated, as suitable for the application. In some embodiments, some or all of the components included in the computing device 2400 may be attached to one or more motherboards. In some embodiments, some or all of these components are fabricated onto a single system on a chip (SoC) die.

Additionally, in various embodiments, the computing device 2400 may not include one or more of the components illustrated in FIG. 11, but the computing device 2400 may include interface circuitry for coupling to the one or more components. For example, the computing device 2400 may not include a display device 2406, but may include display device interface circuitry (e.g., a connector and driver circuitry) to which a display device 2406 may be coupled. In another set of examples, the computing device 2400 may not include an audio input device 2418 or an audio output device 2408, but may include audio input or output device interface circuitry (e.g., connectors and supporting circuitry) to which an audio input device 2418 or audio output device 2408 may be coupled.

The computing device 2400 may include a processing device 2402 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 2402 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices. The computing device 2400 may include a memory 2404, which may itself include one or more memory devices such as volatile memory (e.g., DRAM), nonvolatile memory (e.g., read-only memory (ROM)), flash memory, solid state memory, and/or a hard drive. In some embodiments, the memory 2404 may include memory that shares a die with the processing device 2402.

In some embodiments, the computing device 2400 may include a communication chip 2412 (e.g., one or more communication chips). For example, the communication chip 2412 may be configured for managing wireless communications for the transfer of data to and from the computing device 2400. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 2412 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 2412 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 2412 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 2412 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 2412 may operate in accordance with other wireless protocols in other embodiments. The computing device 2400 may include an antenna 2422 to facilitate wireless communications and/or to receive other wireless communications (such as AM or FM radio transmissions).

In some embodiments, the communication chip 2412 may manage wired communications, such as electrical, optical, or any other suitable communication protocols (e.g., the Ethernet). As noted above, the communication chip 2412 may include multiple communication chips. For instance, a first communication chip 2412 may be dedicated to shorter-range wireless communications such as Wi-Fi or Bluetooth, and a second communication chip 2412 may be dedicated to longer-range wireless communications such as global positioning system (GPS), EDGE, GPRS, CDMA, WiMAX, LTE, EV-DO, or others. In some embodiments, a first communication chip 2412 may be dedicated to wireless communications, and a second communication chip 2412 may be dedicated to wired communications.

The computing device 2400 may include battery/power circuitry 2414. The battery/power circuitry 2414 may include one or more energy storage devices (e.g., batteries or capacitors) and/or circuitry for coupling components of the computing device 2400 to an energy source separate from the computing device 2400 (e.g., AC line power).

The computing device 2400 may include a display device 2406 (or corresponding interface circuitry, as discussed above). The display device 2406 may include any visual indicators, such as a heads-up display, a computer monitor, a projector, a touchscreen display, a liquid crystal display (LCD), a light-emitting diode display, or a flat panel display, for example.

The computing device 2400 may include an audio output device 2408 (or corresponding interface circuitry, as discussed above). The audio output device 2408 may include any device that generates an audible indicator, such as speakers, headsets, or earbuds, for example.

The computing device 2400 may include an audio input device 2418 (or corresponding interface circuitry, as discussed above). The audio input device 2418 may include any device that generates a signal representative of a sound, such as microphones, microphone arrays, or digital instruments (e.g., instruments having a musical instrument digital interface (MIDI) output).

The computing device 2400 may include a GPS device 2416 (or corresponding interface circuitry, as discussed above). The GPS device 2416 may be in communication with a satellite-based system and may receive a location of the computing device 2400, as known in the art.

The computing device 2400 may include an other output device 2410 (or corresponding interface circuitry, as discussed above). Examples of the other output device 2410 may include an audio codec, a video codec, a printer, a wired or wireless transmitter for providing information to other devices, or an additional storage device.

The computing device 2400 may include an other input device 2420 (or corresponding interface circuitry, as discussed above). Examples of the other input device 2420 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 2400 may have any desired form factor, such as a handheld or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, the computing device 2400 may be any other electronic device that processes data.

### Select examples

The following paragraphs provide various examples of the embodiments disclosed herein.
Example 1 provides a transistor arrangement that includes a channel material; a gate electrode material (e.g., the gate electrode material 536, shown in the present drawings) provided over a gate portion of the channel material; a source or drain (S/D) contact material (e.g., the S/D contact material 542, shown in the present drawings), provided adjacent to the gate portion of the channel material; a first electrically conductive material (TCN1 material) (e.g., the first trench contact material 544, shown in the present drawings) provided over the S/D contact material; and a second electrically conductive material (TCN2 material) (e.g., the second trench contact material 554, shown in the present drawings) provided over the TCN1 material. In such a transistor arrangement, a width of the TCN2 material (a dimension measured along the x-axis of the example coordinate system shown in the present drawings) at a first distance from the S/D contact material is greater, e.g., at least about 1 nm greater, than a width of the TCN2 material at a second distance from the S/D contact material, the second distance being greater than the first distance.
Example 2 provides the transistor arrangement according to example 1, where the width of the TCN2 material at the second distance from the S/D contact material is smaller than a width of the TCN1 material.
Example 3 provides the transistor arrangement according to examples 1 or 2, where the gate electrode material is a first gate electrode material, the gate portion of the channel material is a first gate portion of the channel material, the transistor arrangement further includes a second gate electrode material (e.g., the gate electrode material 536, shown in the present drawings) provided over a second gate portion of the channel material, and the TCN1 material is self-aligned between the first gate electrode material and the second gate electrode material, where "self-alignment" may mean that the TCN1 material is substantially equidistant to the first and second gates formed by the first and second gate electrode materials.
Example 4 provides the transistor arrangement according to example 3, where the transistor arrangement further includes one or more gate spacer materials (e.g., gate spacer materials 538, 549, and/or 738, shown in the present drawings) between each of: the TCN1 material and the first gate electrode material, and the TCN1 material and the second gate electrode material.
Example 5 provides the transistor arrangement according to example 4, where no portion of the one or more gate spacer materials is over a top of the first gate electrode material and over a top of the second gate electrode material.
Example 6 provides the transistor arrangement according to examples 4 or 5, further including an etch-stop material (e.g., the ESL material 535-2, shown in the present drawings) provided over, e.g., in contact with, a portion of the gate electrode material.
Example 7 provides the transistor arrangement according to any one of examples 4-6, where a dielectric constant of each of the one or more gate spacer materials is equal to or lower than a dielectric constant of silicon nitride (e.g., lower than about 7-9).
Example 8 provides the transistor arrangement according to any one of examples 4-7, where the one or more gate spacer materials include one or more first gate spacer materials and a replacement gate spacer material. Furthermore, in between each of the TCN1 material and the first gate electrode material, and the TCN1 material and the second gate electrode material: the one or more first gate spacer materials are recessed to be below the TCN1 material, and the replacement gate spacer material is between each of the TCN1 material and the first gate electrode material, and the TCN1 material and the second gate electrode material.
Example 9 provides the transistor arrangement according to example 8, where the transistor arrangement includes a void in at least one of: the replacement gate spacer material between the TCN1 material and the first gate electrode material, and the replacement gate spacer material between the TCN1 material and the second gate electrode material. Such a void may advantageously decrease capacitance between adjacent gate electrode and TCN1 materials, e.g., decrease by about 10-20%.
Example 10 provides the transistor arrangement according to example 9, where a width of the void is at least about half of a width of the one or more first gate spacer materials.
Example 11 provides the transistor arrangement according to any one of the preceding examples, further including a TCN2 spacer material, at least partially enclosing sidewalls of the TCN2 material, where a dielectric constant of the TCN2 spacer material is higher than a dielectric constant of silicon oxide (e.g., higher than about 3.7-4.1).
Example 12 provides the transistor arrangement according to example 11, where the dielectric constant of the TCN2 spacer material is at least about 5.5.
Example 13 provides the transistor arrangement according to examples 11 or 12, further comprising an ILD material, at least partially enclosing sidewalls of the TCN2 spacer material so that the TCN2 spacer material is between the TCN2 material and the ILD material, where a dielectric constant of the ILD material is equal to or lower than the dielectric constant of silicon oxide.
Example 14 provides the transistor arrangement according to any one of the preceding examples, where a top of the TCN1 material is aligned with a top of the gate electrode material.
Example 15 provides the transistor arrangement according to any one of the preceding examples, further comprising: a gate contact via (VCG) provided over a portion of the gate electrode material as a via opening provided over a portion of the gate electrode material, the via opening at least partially filled with a third electrically conductive material (VCG material) (e.g., the VCG material 556, shown in the present drawings), where a width of a portion of the via opening (a dimension measured along the x-axis of the example coordinate system shown in the present drawings) at the first distance from the S/D contact material is smaller, e.g., at least about 1 nm smaller, than a width of the via opening at the second distance from the S/D contact material.
Example 16 provides the transistor arrangement according to any one of the preceding examples, where a portion of the TCN2 material is provided over, e.g., in contact with, a portion of a top of the gate electrode material.
Example 17 provides the transistor arrangement according to any one of the preceding examples, where a width of the TCN1 material at a third distance from the S/D contact material is equal to or smaller, e.g., at least about 1 nm smaller, than a width of the TCN2 material at a fourth distance from the S/D contact material, the fourth distance being greater than the third distance.
Example 18 provides the transistor arrangement according to any one of the preceding examples, where the channel material is shaped as a fin or as a nanoribbon.
Example 19 provides the transistor arrangement according to any one of the preceding examples, where the transistor arrangement is a part of at least one of a memory device, a computing device, a wearable device, a handheld electronic device, and a wireless communications device.
Example 20 provides a transistor arrangement that includes a channel (e.g., a portion of the channel material 534, shown in the present drawings); a gate (e.g., one of the gates 536, shown in the present drawings) provided over the channel; a source or drain (S/D) contact material (e.g., the S/D contact material 542, shown in the present drawings), adjacent to the channel; a first electrically conductive material (TCN1 material) (e.g., the first trench contact material 544, shown in the present drawings); a second electrically conductive material (TCN2 material) (e.g., the second trench contact material 554, shown in the present drawings), where the TCN1 material is between the S/D contact material and the TCN2 material; and a TCN2 spacer (e.g., the TCN2 spacer material 552, shown in the present drawings), at least partially enclosing sidewalls of the TCN2 material, where a dielectric constant of the TCN2 spacer material is higher than a dielectric constant of silicon oxide (e.g., higher than about 3.7-4.1).
Example 21 provides the transistor arrangement according to example 20, where a portion of the TCN2 material is provided over, e.g., in contact with, a portion of a top of the gate and is electrically coupled to the gate.
Example 22 provides the transistor arrangement according to example 21, where the portion of the TCN2 material that is over the portion of the top of the gate overlaps with the gate by at least about 50 percent of a width of the gate (a dimension measured along the x-axis of the example coordinate system shown in the present drawings).
Example 23 provides the transistor arrangement according to any one of examples 20-22, where the channel is a portion of a channel material, the channel material shaped as a fin or as a nanoribbon.
Example 24 provides the transistor arrangement according to any one of examples 20-23, where: the gate is a first gate, the channel material is a first channel, the transistor arrangement further includes a second gate provided over a second channel, and the transistor arrangement further includes an etch-stop material (e.g., the ESL material 535-2, shown in the present drawings) provided over, e.g., in contact with, at least a portion of the second gate.
Example 25 provides the transistor arrangement according to any one of examples 20-24, where the dielectric constant of the TCN2 spacer is at least about 5.5.
Example 26 provides a method of fabricating a transistor arrangement, the method comprising: providing a channel of a transistor; providing a gate (e.g., the gate electrode material 536, shown in the present drawings) of the transistor over the channel; providing a source or drain (S/D) contact material (e.g., the S/D contact material 542, shown in the present drawings) adjacent to the channel; providing a first electrically conductive material (TCN1 material) (e.g., the first trench contact material 544, shown in the present drawings); and providing a second electrically conductive material (TCN2 material) (e.g., the second trench contact material 548, shown in the present drawings) so that the TCN1 material is between the S/D contact material and the TCN2 material, where a width of the TCN2 material (a dimension measured along the x-axis of the example coordinate system shown in the present drawings) at a first distance from the S/D contact material is greater, e.g., at least about 1 nm greater, than a width of the TCN2 material at a second distance from the S/D contact material, the second distance being greater than the first distance.
Example 27 provides the method according to example 26, further including providing a TCN2 spacer, at least partially enclosing sidewalls of the TCN2 material, where a dielectric constant of the TCN2 spacer material is higher than a dielectric constant of silicon oxide (e.g., higher than about 3.7-4.1). In further examples, the method according to any one of examples 26-27 may further include processes for forming the transistor arrangement according to any one of the preceding examples (e.g., the transistor arrangement according to any one of examples 1-26)
Example 28 provides an IC package, comprising: an IC die, comprising a transistor arrangement according to any one of examples 1-26; and a further IC component, coupled to the IC die.
Example 29 provides the IC package according to example 28, where the further IC component includes one of a package substrate, an interposer, or a further IC die.
Example 30 provides the IC package according to examples 28 or 29, where the IC die includes, or is a part of, at least one of a memory device and a computing device.
Example 31 provides the IC package according to examples 28 or 29, where the IC die includes, or is a part of, a wearable device or a handheld electronic device.
Example 32 provides the IC package according to examples 28 or 29, where the IC die includes, or is a part of a wireless communications device.
Example 33 provides an electronic device, comprising: a carrier substrate; and an IC die coupled to the carrier substrate, where the IC die: includes the transistor arrangement according to any one of examples 1-26, and is included in the IC package according to any one of examples 28-32
Example 34 provides the electronic device according to example 33, where the electronic device is a wearable electronic device (e.g., a smart watch) or handheld electronic device (e.g., a mobile phone).
Example 35 provides the electronic device according to examples 33 or 34, where the electronic device further includes one or more communication chips and an antenna.
Example 36 provides the electronic device according to any one of examples 33-35, where the carrier substrate is a motherboard.
Example 37 provides the electronic device according to any one of examples 33-36, where the electronic device is an RF transceiver.
Example 38 provides the electronic device according to any one of examples 33-37, where the electronic device is one of a switch, a power amplifier, a low-noise amplifier, a filter, a filter bank, a duplexer, an upconverter, or a downconverter of an RF communications device, e.g., of an RF transceiver.
Example 39 provides the electronic device according to any one of examples 33-38, where the electronic device is included in a base station of a wireless communication system.
Example 40 provides the electronic device according to any one of examples 33-38, where the electronic device is included in a user equipment device (i.e., a mobile device) of a wireless communication system.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. A transistor arrangement, comprising:
a channel material;
a gate electrode material over a gate portion of the channel material;
a source or drain (S/D) contact material adjacent to the gate portion;
a first electrically conductive material (TCN1 material) over the S/D contact material; and
a second electrically conductive material (TCN2 material) over the TCN1 material, wherein a width of the TCN2 material at a first distance from the S/D contact material is greater than a width of the TCN2 material at a second distance from the S/D contact material, the second distance being greater than the first distance.

2. The transistor arrangement according to claim 1, wherein the width of the TCN2 material at the second distance from the S/D contact material is smaller than a width of the TCN1 material.

3. The transistor arrangement according to claims 1 or 2, wherein:
the gate electrode material is a first gate electrode material,
the gate portion of the channel material is a first gate portion of the channel material,
the transistor arrangement further includes a second gate electrode material over a second gate portion of the channel material, and
the TCN1 material is self-aligned between the first gate electrode material and the second gate electrode material,

4. The transistor arrangement according to claim 3, wherein the transistor arrangement further includes one or more gate spacer materials between at least one of:
the TCN1 material and the first gate electrode material, and
the TCN1 material and the second gate electrode material.

5. The transistor arrangement according to claim 4, wherein no portion of the one or more gate spacer materials is over a top of the first gate electrode material.

6. The transistor arrangement according to claims 4 or 5, wherein a dielectric constant of at least one of the one or more gate spacer materials is equal to or lower than a dielectric constant of silicon nitride.

7. The transistor arrangement according to any one of claims 4-6, wherein the one or more gate spacer materials include one or more first gate spacer materials and a replacement gate spacer material, and wherein in between at least one of the TCN1 material and the first gate electrode material, and the TCN1 material and the second gate electrode material:
the one or more first gate spacer materials are recessed to be below the TCN1 material, and
the replacement gate spacer material is between at least one of the TCN1 material and the first gate electrode material, and the TCN1 material and the second gate electrode material.

8. The transistor arrangement according to claim 7, wherein the transistor arrangement includes a void in at least one of:
the replacement gate spacer material between the TCN1 material and the first gate electrode material, and
the replacement gate spacer material between the TCN1 material and the second gate electrode material.

9. The transistor arrangement according to claim 8, wherein a width of the void is at least about half of a width of the one or more first gate spacer materials.

10. The transistor arrangement according to any one of claims 1-9, further comprising a TCN2 spacer material, at least partially enclosing sidewalls of the TCN2 material, where a dielectric constant of the TCN2 spacer material is at least about 5.5.

11. The transistor arrangement according to any one of claims 1-10, further comprising, over a portion of the gate electrode material, the via opening at least partially filled with a third electrically conductive material (VCG material), wherein a width of a portion of the via opening at the first distance from the S/D contact material is smaller, than a width of the via opening at the second distance from the S/D contact material.

12. An integrated circuit (IC) package, comprising:
an IC die, comprising a transistor arrangement according to any one of the preceding claims; and
a further IC component, coupled to the IC die.

13. An electronic device, comprising:
a carrier substrate; and
an integrated circuit (IC) die coupled to the carrier substrate, wherein the IC die includes a transistor arrangement according to any one of the preceding claims.

14. A method of fabricating a transistor arrangement, the method comprising:
providing a channel of a transistor;
providing a gate of the transistor over the channel;
providing a source or drain (S/D) contact material adjacent to the channel;
providing a first electrically conductive material (TCN1 material); and
providing a second electrically conductive material (TCN2 material) so that the TCN1 material is between the S/D contact material and the TCN2 material, wherein a width of the TCN2 material at a first distance from the S/D contact material is greater, than a width of the TCN2 material at a second distance from the S/D contact material, the second distance being greater than the first distance.

15. The method according to claim 14, further including providing a TCN2 spacer that at least partially encloses sidewalls of the TCN2 material, where a dielectric constant of the TCN2 spacer material is higher than a dielectric constant of silicon oxide.
